# EUROPEAN PATENT APPLICATION

(11) **EP 4 761 489 A1**
(43) Date of publication of application: **17.06.2026**
(21) Application number: 25781897.1
(22) Date of filing: 02.04.2025
(51) Int. Cl.: H05K 7/20, H01R 4/64

(54) **VAPOR CHAMBER AND ELECTRONIC DEVICE**

(30) Priority: 03.04.2024 CN 202410405001
(71) Applicant: HUAWEI TECHNOLOGIES CO., LTD., Shenzhen 518129 (CN)
(72) Inventor: LUO, Yang, Shenzhen, Guangdong 518129 (CN); CHEN, Qiu, Shenzhen, Guangdong 518129 (CN); CHEN, Qi, Shenzhen, Guangdong 518129 (CN); LIU, Yonglu, Shenzhen, Guangdong 518129 (CN); JIN, Linfang, Shenzhen, Guangdong 518129 (CN)
(74) Representative: Pfenning, Meinig & Partner mbB
(86) International application number: PCT/CN2025/086781
(87) International publication number: WO 2025/209505

(57) **Abstract**

This application provides a vapor chamber and an electronic device. The vapor chamber includes a first cover, a second cover, a capillary structure, a cooling medium, and a first conductive member. The first cover includes a first conductive layer, a first insulation layer, and a second conductive layer. The first insulation layer is connected between the first conductive layer and the second conductive layer. The second conductive layer is located on a side that is of the first insulation layer and that is close to the second cover. A part of the first conductive member is connected to the first conductive layer, and a part of the first conductive member is connected to the second cover. The first conductive layer is electrically connected, through the first conductive member, to a surface that is of the second cover and that is away from an accommodating cavity. When the vapor chamber is used in an electronic device, regardless of whether an electrical connection member of the electronic device is electrically connected to a top surface or a bottom surface of the vapor chamber, the other one may be electrically connected to a ground location of the vapor chamber through the first conductive member, to ensure good grounding reliability of the top surface and the bottom surface of the vapor chamber. In this case, a risk that RSE occurs on the electronic device is relatively low.

## Description

This application claims priority to Chinese Patent Application No. 202410405001.8, filed with the China National Intellectual Property Administration on April 3, 2024 and entitled "VAPOR CHAMBER AND ELECTRONIC DEVICE", which is incorporated herein by reference in its entirety.

### TECHNICAL FIELD

This application relates to the field of heat dissipation technologies, and in particular, to a vapor chamber and an electronic device.

### BACKGROUND

With miniaturization development of an electronic device such as a mobile phone, a tablet, or a computer, an integration level of an electronic component in the electronic device is continuously improved, causing a sharp increase of heat emitted by the electronic device. To avoid impact on performance of the electronic device due to an excessively large amount of generated heat, currently, a vapor chamber is usually used in the electronic device to dissipate heat of the electronic component.

Due to development of a lightweight requirement of the electronic device, a cover of the vapor chamber uses a metal layer-organic insulation layer-metal layer stacked structure, and replaces a part of metal material with an organic insulating material, thereby reducing mass of the vapor chamber. Due to the addition of the organic insulation layer, upper and lower surfaces of the vapor chamber are insulated. Both the upper and lower surfaces of the vapor chamber are made of a metal material. In a use process of the electronic device, unstable electrical conduction occurs between the upper surface and/or the lower surface of the vapor chamber and a screen or another electriferous structure in the electronic device under external force, a radiated spurious emission (radiated spurious emission, RSE) signal is generated at a contact location, affecting a wireless communication signal of the electronic device.

### SUMMARY

This application provides a vapor chamber and an electronic device.

According to a first aspect, an embodiment of this application provides a vapor chamber. The vapor chamber includes a first cover, a second cover, a capillary structure, a cooling medium, and a first conductive member. The second cover includes an effective region and an edge sealing region. The edge sealing region is connected to a peripheral edge of the effective region. A part of the first cover is fastened to the edge sealing region of the second cover, and a part of the first cover is spaced from the effective region of the second cover, to enclose an accommodating cavity. The capillary structure and the cooling medium are located in the accommodating cavity. The first cover includes a first conductive layer, a first insulation layer, and a second conductive layer. The first insulation layer is connected between the first conductive layer and the second conductive layer. The second conductive layer is located on a side that is of the first insulation layer and that is close to the second cover. A part of the first conductive member is connected to the first conductive layer, and a part of the first conductive member is connected to the second cover. The first conductive layer is electrically connected, through the first conductive member, to a surface that is of the second cover and that is away from the accommodating cavity.

It may be understood that the vapor chamber may include a top surface and a bottom surface that are disposed opposite to each other. A surface on a side that is of the first conductive layer and that is away from the accommodating cavity may be the top surface of the vapor chamber, and a surface on a side that is of the second cover and that is away from the accommodating cavity may be the bottom surface of the vapor chamber. Alternatively, a surface on a side that is of the first conductive layer and that is away from the accommodating cavity may be the bottom surface of the vapor chamber, and a surface on a side that is of the second cover and that is away from the accommodating cavity may be the top surface of the vapor chamber.

The first conductive layer is electrically connected, through the first conductive member, to the surface that is of the second cover and that is away from the accommodating cavity, to implement electrical conduction between the top surface and the bottom surface of the vapor chamber. When the vapor chamber is configured to dissipate heat in the electronic device, and unstable electrical conduction occurs between the top surface and/or the bottom surface of the vapor chamber and a screen of the electronic device or another electriferous structure in the electronic device, regardless of whether an electrical connection member of the electronic device is electrically connected to the top surface or the bottom surface of the vapor chamber, the other one may be electrically connected to a ground location of the vapor chamber through the first conductive member, to ensure good grounding reliability of the top surface and the bottom surface of the vapor chamber.

In some possible implementations, the second cover includes a third conductive layer and a second insulation layer that are stacked, and the second insulation layer is located on a side that is of the third conductive layer and that is close to the second conductive layer. A part of the first conductive member is fastened to the first conductive layer, and a part of the first conductive member is fastened to the third conductive layer. The first conductive layer is electrically connected to the third conductive layer through the first conductive member.

It may be understood that the second insulation layer may be made of an organic polymer material. Compared with a solution in which the second cover is prepared by using a conductive metal material as a whole, the first insulation layer is prepared by using a polymer insulating material to replace a part of a metal layer, to reduce average density of the second cover, thereby reducing overall mass of the vapor chamber.

In some possible implementations, the first conductive member and the first conductive layer are an integrally formed mechanical member. An integral mechanical member formed by two components through an integral forming process means that, in a process of forming one of the two components, the component is connected to the other component, and the two components can be connected together without reprocessing (for example, bonding, welding, a buckle connection, or a screw connection).

It may be understood that, compared with an externally connected independent conductive member, connection strength between the first conductive member and the first conductive layer is better, to simplify a step of preparing the vapor chamber.

In some possible implementations, a part of the first conductive member is fastened to a side surface of the first conductive layer, and a part of the first conductive member is fastened to a side surface of the third conductive layer. Alternatively, a part of the first conductive member is fastened to a side surface of the first conductive layer, and a part of the first conductive member is fastened to a surface that is of the third conductive layer and that is away from the accommodating cavity.

It may be understood that the first conductive member is fastened to the side surface of the first conductive layer and the side surface of the third conductive layer, without additionally increasing a thickness of the vapor chamber. This facilitates thinning of the vapor chamber, so that the vapor chamber is applicable to an electronic device with a relatively small thickness.

The part of the first conductive member is fastened to the side surface of the first conductive layer, and the part of the first conductive member is fastened to the surface that is of the third conductive layer and that is away from the accommodating cavity. A connection area between the first conductive member and the second cover may be relatively large, connection difficulty is relatively low, and electrical connection reliability is relatively high.

In some possible implementations, the vapor chamber further includes a second conductive member. A part of the second conductive member is fastened to the third conductive layer, and a part of the second conductive member is fastened to the first conductive member. The first conductive layer is electrically connected to the third conductive layer through the first conductive member and the second conductive member.

It may be understood that the first conductive layer may be electrically connected to the third conductive layer of the second cover through the first conductive member and the second conductive member, to implement electrical conduction between the top surface and the bottom surface of the vapor chamber.

In some possible implementations, the second conductive member and the third conductive layer are an integrally formed mechanical member.

In this way, connection strength between the second conductive member and the third conductive layer is better, to simplify a step of preparing the vapor chamber.

In some possible implementations, the first conductive member and the second conductive member are arranged in a first direction, and the first direction is a direction from the second cover to the first cover. Alternatively, a part of the second conductive member is fastened to a side that is of the first conductive member and that is away from the accommodating cavity. Alternatively, a part of the first conductive member is fastened to a side that is of the second conductive member and that is away from the accommodating cavity.

It may be understood that the first conductive member and the second conductive member are arranged in the first direction, and the first direction is consistent with a stacking direction of the first conductive layer and the third conductive layer. When the first conductive member and the second conductive member are prepared through an integral forming process, a plate material for preparing the first cover and the second cover may be directly processed through press-fitting or by using a cutting tool, to remove an insulation layer in the plate material, thereby implementing fastening and electrical conduction of the first conductive member and the second conductive member. The process is relatively simple.

The part of the second conductive member is connected to an outer side surface of the first conductive member, or the part of the first conductive member is connected to an outer side surface of the second conductive member. End faces of the two parts do not need to be aligned. A process is simple, manufacturing difficulty is low, and a product yield rate is relatively high. In addition, an upper limit of a connection area between the second conductive member and the first conductive member may be set to relatively large. For example, in a Z-axis direction, a maximum connection area length of the second conductive member and the first conductive member may reach a sum of a thickness of the first conductive layer, a thickness of the second conductive layer, a thickness of the first insulation layer, a thickness of the fourth conductive layer, and a thickness of the second insulation layer. The outer side surface of the first conductive member is the surface that is of the first conductive member and that is away from the accommodating cavity. The outer side surface of the second conductive member is the surface that is of the second conductive member and that is away from the accommodating cavity.

In some possible implementations, the second cover further includes a fourth conductive layer. The fourth conductive layer is stacked on the second insulation layer. The fourth conductive layer is located on a side that is of the second insulation layer and that is close to the accommodating cavity.

It may be understood that the second cover uses a three-layer structure including two conductive layers and one insulation layer sandwiched between the two conductive layers, and the fourth conductive layer is in contact with the cooling medium. This can avoid a case of generating a gas when the second insulation layer is in direct contact with the cooling medium, and sealing reliability between the first cover and the second cover is relatively good.

In some possible implementations, the vapor chamber further includes a third conductive member, the third conductive member is fastened between the first conductive member and the second conductive member, and the first conductive layer is electrically connected to the third conductive layer through the first conductive member, the third conductive member, and the second conductive member.

Alternatively, the vapor chamber further includes a fourth conductive member, the fourth conductive member is fastened between the first conductive member and the second conductive member, and the first conductive layer is electrically connected to the third conductive layer through the first conductive member, the fourth conductive member, and the second conductive member.

Alternatively, the vapor chamber further includes a third conductive member and a fourth conductive member, the first conductive member, the third conductive member, the fourth conductive member, and the second conductive member are arranged in a first direction, the third conductive member is fastened between the fourth conductive member and the first conductive layer, the fourth conductive member is fastened between the third conductive member and the second conductive member, the first conductive layer is electrically connected to the third conductive layer through the first conductive member, the third conductive member, the fourth conductive member, and the second conductive member, and the first direction is a direction from the second cover to the first cover.

It may be understood that the vapor chamber may further include the third conductive member and/or the fourth conductive member. More conductive members are added, and strength of a conductive structure is higher. In addition, a plurality of layers of conductive members are stacked, to further seal the accommodating cavity of the vapor chamber.

In some possible implementations, the third conductive member and the second conductive layer are an integrally formed mechanical member, and/or the fourth conductive member and the fourth conductive layer are an integrally formed mechanical member.

It may be understood that connection strength between the third conductive member and the second conductive layer is better; and/or connection strength between the fourth conductive member and the fourth conductive layer is better.

In some possible implementations, a part of the first conductive member is fastened to the first conductive layer, and a part of the first conductive member is fastened to the second conductive layer; and a part of the second conductive member is fastened to the third conductive layer, and a part of the second conductive member is fastened to the fourth conductive layer.

The second conductive layer is electrically connected to the fourth conductive layer, and the first conductive layer is electrically connected to the third conductive layer through the first conductive member, the second conductive layer, the fourth conductive layer, and the second conductive member.

It may be understood that the first conductive member and the second conductive member may not be in direct contact and directly connected, but indirectly implement electrical conduction by using some conductive layers in the first cover and the second cover. A step of fastening and connecting the first conductive member and the second conductive member may be omitted, thereby simplifying an assembly process.

In some possible implementations, a projection of the first conductive member on a reference plane in a first direction and a projection of the second conductive member on the reference plane in the first direction are at least partially staggered, the reference plane is a plane on which the first conductive layer is located, and the first direction is a direction from the second cover to the first cover.

Alternatively, the first conductive member and the second conductive member are spaced.

It may be understood that the first conductive member and the second conductive member may not be in direct contact and directly connected, but indirectly implement electrical conduction by using some conductive layers in the first cover and the second cover. In a process of assembling the first cover and the second cover, the first conductive member and the second conductive member do not need to be accurately aligned, to implement fastening and an electrical connection. An assembly precision requirement is relatively low, and difficulty is relatively low.

In some possible implementations, the first conductive member is an independent mechanical member.

It may be understood that an independent mechanical member means that a process of preparing the first conductive member is an independent process. A process of externally connecting the first conductive member to the second cover or the first conductive layer is simple. The costs of the process are lower.

In some possible implementations, a part of the first conductive member is fastened to a side surface of the first conductive layer, and a part of the first conductive member is fastened to a side surface of the third conductive layer.

It may be understood that the first conductive member is fastened to the side surface of the first conductive layer and the side surface of the third conductive layer, without additionally increasing a thickness of the vapor chamber. This facilitates thinning of the vapor chamber.

In some possible implementations, a part of the first conductive member is fastened to a surface that is of the first conductive layer and that is away from the accommodating cavity, and a part of the first conductive member is fastened to a side surface of the third conductive layer. Alternatively, a part of the first conductive member is fastened to a side surface of the first conductive layer, and a part of the first conductive member is fastened to a surface that is of the third conductive layer and that is away from the accommodating cavity. Alternatively, a part of the first conductive member is fastened to a surface that is of the first conductive layer and that is away from the accommodating cavity, and a part of the first conductive member is fastened to a surface that is of the third conductive layer and that is away from the accommodating cavity.

It may be understood that the surface that is of the first conductive layer and that is away from the accommodating cavity may be the top surface of the vapor chamber, and the surface that is of the third conductive layer and that is away from the accommodating cavity may be the bottom surface of the vapor chamber. At least a part of the first conductive member is fastened to the top surface of the vapor chamber and/or is fastened to the bottom surface of the vapor chamber. In this embodiment, an electrical connection area between the first conductive member and the first conductive layer or between the first conductive member and the second cover is less limited, and a connection area between the first conductive member and the first conductive layer and a connection area between the first conductive member and the second cover may be set to relatively large. This process is relatively simple, and electrical connection reliability is relatively good.

In some possible implementations, the first conductive member includes a first submember and a second submember. A part of the first submember is fastened to a surface that is of the first conductive layer and that is away from the first insulation layer, and a part of the first submember is fastened to the second submember. A part of the second submember is fastened to a surface that is of the third conductive layer and that is away from the second insulation layer. The first submember and the second submember are two independent mechanical members, or the first submember and the second submember are an integrally formed mechanical member.

It may be understood that the first conductive member may have a free end (that is, a connection part of a first part and a second part) that extends out. When the vapor chamber is installed on an electronic device, the free end may be longer to be directly connected to the middle frame or the screen, to implement an electrical connection. In other words, when the free end of the first conductive member is long enough, the vapor chamber may be electrically connected to the screen or the vapor chamber may be electrically connected to the middle frame at a place away from the vapor chamber.

In some possible implementations, the first cover is provided with a first through hole, the first through hole penetrates the first conductive layer, the first insulation layer, and the second conductive layer, a second through hole is provided in the edge sealing region of the second cover, the second through hole penetrates the second insulation layer and a third conductive layer, the first through hole and the accommodating cavity are spaced, and the first through hole communicates with the second through hole. A part of the first conductive member is located in the first through hole, and a part of the first conductive member is located in the second through hole. One end of the first conductive member is fastened to the first conductive layer, and the other end of the first conductive member is fastened to the third conductive layer. The first conductive layer is electrically connected to the third conductive layer through the first conductive member.

It may be understood that, in a manner of providing a through hole, the first conductive member is located in the first through hole and the second through hole, the first conductive member is not prone to falling out of the first through hole and the second through hole, and reliability of an electrical connection between the first conductive layer and the second cover is relatively good.

In some possible implementations, the first cover is provided with a first through hole, the first through hole penetrates the first conductive layer and the first insulation layer, the edge sealing region of the second cover is provided with a second through hole, and the second through hole penetrates the second insulation layer and the third conductive layer. A projection of the first through hole on a reference plane in a first direction and a projection of the second through hole on the reference plane in the first direction are staggered. The second conductive layer is exposed from the second through hole. The reference plane is a plane on which the first conductive layer is located. The first direction is a direction from the second cover to the first cover. The vapor chamber further includes a fifth conductive member. The first conductive member is located in the first through hole. One end of the first conductive member is fastened to the first conductive layer, and the other end of the first conductive member is fastened to the second conductive layer. The fifth conductive member is located in the second through hole. One end of the fifth conductive member is fastened to the second conductive layer, and the other end of the fifth conductive member is fastened to the third conductive layer. The first conductive layer is electrically connected to the third conductive layer through the first conductive member, the second conductive layer, and the fifth conductive member.

It may be understood that, when locations of the first through hole and the second through hole are selectively set, a conductive layer of the first cover 1 and/or the second cover may be used for electrical conduction between the first conductive layer 1 and the third conductive layer 1, and layers that the first through hole and the second through hole respectively penetrate may be selected according to an actual situation.

The projection of the first through hole on the reference plane in the first direction and the projection of the second through hole on the reference plane in the first direction are staggered. When the first cover 1 and the second cover are assembled, an assembly precision requirement is relatively low.

In some possible implementations, the second cover is made of a conductive material.

It may be understood that the second cover being made of the conductive material may include that the second cover may be made of a conductive material at an entire layer, or the second cover may include a plurality of layers of conductive materials. When the first conductive member needs to be electrically connected to a surface that is of the second cover and that is in an accommodating cavity, the first conductive member may be fastened to any location at the second cover. This may implement the electrical connection between the first conductive member and the second cover.

In some possible implementations, the first cover is provided with a first through hole, the first through hole penetrates the first conductive layer, the first insulation layer, and the second conductive layer, the first through hole and the accommodating cavity are spaced, and the second cover is exposed from the first through hole. The first conductive member is located in the first through hole. One end of the first conductive member is fastened to the first conductive layer, and the other end of the first conductive member is fastened to the second cover.

It may be understood that the second cover may not be provided with a second through hole. The first conductive layer may be electrically connected to the second cover through the first conductive member and the second conductive layer.

In some possible implementations, the first cover is provided with a first through hole, the first through hole penetrates the first conductive layer and the first insulation layer, the first through hole and the accommodating cavity are spaced, and the second conductive layer is exposed from the first through hole. The first conductive member is located in the first through hole. One end of the first conductive member is fastened to the first conductive layer and electrically connected to the first conductive layer, and the other end of the first conductive member is fastened to the second conductive layer and electrically connected to the second conductive layer. The second conductive layer is electrically connected to the second cover.

In this way, the first conductive layer may be electrically connected to the second cover through the first conductive member and the second conductive layer.

In some possible implementations, the first conductive member is of a solid structure. In this way, strength of the first conductive member is better, and stability of an electrical connection between the first conductive layer and the second cover is better.

In some possible implementations, the first conductive member is of a hollow-out structure. In this way, material costs of the first conductive member are lower, and a weight of the first conductive member is smaller. This facilitates lightening of the vapor chamber.

In some possible implementations, the second cover includes a top surface, a bottom surface, and a side surface, the bottom surface and the top surface are disposed opposite to each other, the side surface is connected between the top surface and the bottom surface, and the top surface faces the accommodating cavity. The first conductive layer includes a first part, a second part, and a third part. The first insulation layer includes a first part, a second part, and a third part. The first part of the first insulation layer and the top surface are disposed opposite to each other. The first part of the first conductive layer is located on a side that is of the first part of the first insulation layer and that is away from the top surface. The second part of the first insulation layer and the side surface are disposed opposite to each other. The second part of the first conductive layer is disposed on a side that is of the second part of the first insulation layer and that is away from the side surface. The third part of the first insulation layer and the bottom surface are disposed opposite to each other. The third part of the first conductive layer is located on a side that is of the third part of the first insulation layer and that is away from the bottom surface. A part of the first conductive member is fastened to the third part of the first conductive layer, and a part of the first conductive member is fastened to the bottom surface of the second cover. The first conductive layer is electrically connected to the bottom surface of the second cover through the first conductive member.

It may be understood that, when the vapor chamber is installed on the electronic device, a surface on a side that is of the second cover and that is away from the second conductive layer may be fastened to the middle frame. In this case, the first conductive member may be located between the middle frame and the second cover. In a process of using the electronic device, the first conductive member is not prone to fall-off when the electronic device is in scenarios such as falling, collision, and extrusion. Electrical connection reliability is higher.

According to a second aspect, an embodiment of this application provides an electronic device. The electronic device includes a support member and a vapor chamber. The vapor chamber is installed on the support member.

It may be understood that, when unstable electrical conduction occurs between a top surface and/or a bottom surface of the vapor chamber and a screen of the electronic device or another electriferous structure in the electronic device in a process of using the electronic device, regardless of whether an electrical connection member of the electronic device is electrically connected to the top surface or the bottom surface of the vapor chamber, the other one may be electrically connected to a ground location of the vapor chamber through the first conductive member, to ensure stable grounding of the top surface and the bottom surface of the vapor chamber and further lower a risk of generating a radiation spurious emission (radiated spurious emission, RSE) signal. A wireless communication signal of the electronic device is relatively good.

In some possible implementations, the electronic device further includes a screen and a housing. The screen is installed in the housing. The screen and the housing enclose an accommodation space. The vapor chamber is installed in the accommodation space. The support member is the screen or the housing.

It may be understood that a location of the vapor chamber in the electronic device may be set according to a component arrangement requirement.

In some possible implementations, the housing includes a middle frame and a rear cover. The middle frame is connected between the screen and the rear cover. The screen, the middle frame, and the rear cover enclose the accommodation space. The support member is the middle frame or the rear cover.

It may be understood that a location of the vapor chamber in the electronic device may be set according to a component arrangement requirement. A ground end of the electronic device is usually the middle frame. When the vapor chamber is installed on the middle frame or the rear cover, the vapor chamber is easily grounded.

In some possible implementations, the first conductive member of the vapor chamber is fastened to the middle frame and is electrically connected to the middle frame.

It may be understood that the middle frame is electrically connected through the first conductive member, and no electrical connection structure needs to be additionally disposed between the vapor chamber and the middle frame. In addition, the first conductive member of the vapor chamber may be further configured to strengthen a connection between the vapor chamber and the middle frame.

In some possible implementations, the electronic device further includes a first electrical connection member. A part of the first electrical connection member is fastened to the vapor chamber and electrically connected to a first conductive layer of the vapor chamber, and a part of the first electrical connection member is fastened to the middle frame and electrically connected to the middle frame.

It may be understood that, when a back adhesive is an insulating material, the first electrical connection member may be disposed, so that both the second cover and the first conductive layer of the vapor chamber can be electrically connected to the middle frame through the first electrical connection member. For example, the first electrical connection member is electrically connected to the first conductive layer of the vapor chamber. The bottom surface of the vapor chamber may be electrically connected to the first conductive layer through the first conductive member, and further grounded through the first electrical connection member. The first conductive layer may be directly grounded through the first electrical connection member. Therefore, when the top surface or the bottom surface of the vapor chamber is in unstable electrical contact with an electriferous component in the electronic device, a current may be grounded through the first electrical connection member.

In some possible implementations, the vapor chamber has an extension region, a gap exists between a bottom surface of the extension region and the middle frame, and at least a part of the first electrical connection member is located in the gap.

It may be understood that the first electrical connection member is not prone to fall-off from the middle frame or the vapor chamber.

In some possible implementations, the first electrical connection member is a conductive slurry, a conductive adhesive, conductive foam, or a metal sheet.

According to a third aspect, an embodiment of this application provides an electronic device. The electronic device includes a housing, a screen, a vapor chamber, and an electrical connection structure. The screen is connected to the housing to enclose an accommodation space. Both the vapor chamber and the electrical connection structure are installed in the accommodation space. One end of the electrical connection structure is connected to the vapor chamber, and the other end of the electrical connection structure is connected to the housing or the screen.

The vapor chamber includes a first cover, a second cover, a capillary structure, and a cooling medium. The second cover includes an effective region and an edge sealing region. The edge sealing region is connected to a peripheral edge of the effective region. A part of the first cover is fastened to the edge sealing region of the second cover, and a part of the first cover is spaced from the effective region of the second cover, to enclose an accommodating cavity. The capillary structure and the cooling medium are located in the accommodating cavity.

The first cover includes a first conductive layer, a first insulation layer, and a second conductive layer. The first insulation layer is connected between the first conductive layer and the second conductive layer. The second conductive layer is located on a side that is of the first insulation layer and that is close to the second cover.

The second cover is made of a conductive material. A part of the electrical connection structure is electrically connected to the first conductive layer and the second cover, and a part of the electrical connection structure is electrically connected to a ground end of the electronic device.

Alternatively, the second cover includes a third conductive layer and a second insulation layer that are stacked. The second insulation layer is located on a side that is of the third conductive layer and that is close to the second conductive layer. A part of the electrical connection structure is electrically connected to the first conductive layer and the third conductive layer, and a part of the electrical connection structure is electrically connected to a ground end of the electronic device.

It may be understood that, by disposing the electrical connection structure, when unstable electrical conduction occurs between a top surface and/or a bottom surface of the vapor chamber and a screen or another electriferous structure in the electronic device in a process of using the electronic device, the top surface and the bottom surface of the vapor chamber may be grounded through the electrical connection structure, to further lower a risk of generating a radiation spurious emission (radiated spurious emission, RSE) signal. A wireless communication signal of the electronic device is relatively good.

### BRIEF DESCRIPTION OF DRAWINGS

To describe technical solutions in embodiments of this application, the following describes accompanying drawings used in embodiments of this application.
FIG. 1 is a diagram of a structure of an implementation of an electronic device according to an embodiment of this application;
FIG. 2 is a partial exploded view of an implementation of the electronic device shown in FIG. 1;
FIG. 3 is a diagram of a partial structure of an implementation of the electronic device shown in FIG. 1 along a line A-A;
FIG. 4 is a partial sectional view of an implementation of a vapor chamber shown in FIG. 3 at another angle;
FIG. 5 is an enlarged diagram of an implementation of a structure shown in FIG. 4 at a location B;
FIG. 6a is a diagram of an implementation of the vapor chamber shown in FIG. 4 at another angle;
FIG. 6b is a diagram of another implementation of the vapor chamber shown in FIG. 4 at another angle;
FIG. 7a is a diagram of a structure of another implementation of a structure shown in FIG. 4;
FIG. 7b is a diagram of a structure of an implementation of the structure shown in FIG. 7a at another angle;
FIG. 8 is a partial sectional view of an implementation of a vapor chamber shown in FIG. 3;
FIG. 9 is a diagram of a structure of another implementation of a structure shown in FIG. 4 at a location B;
FIG. 10 is a diagram of a structure of still another implementation of a structure shown in FIG. 4 at a location B;
FIG. 11 is a diagram of a structure of yet another implementation of a structure shown in FIG. 4 at a location B;
FIG. 12 is a diagram of a structure of yet another implementation of a structure shown in FIG. 4 at a location B;
FIG. 13 is a diagram of a structure of still another implementation of the structure shown in FIG. 12;
FIG. 14 is a diagram of a structure of yet another implementation of a structure shown in FIG. 4 at a location B;
FIG. 15 is a diagram of a structure of still another implementation of the structure shown in FIG. 14;
FIG. 16 is a diagram of a structure of another implementation of the structure shown in FIG. 14;
FIG. 17 is a diagram of a structure of still another implementation of the structure shown in FIG. 16;
FIG. 18 is a diagram of a structure of still another implementation of the structure shown in FIG. 14;
FIG. 19 is a diagram of a structure of still another implementation of the structure shown in FIG. 18;
FIG. 20 is a diagram of a structure of still another implementation of the structure shown in FIG. 18;
FIG. 21 is a diagram of a structure of still another implementation of the structure shown in FIG. 19;
FIG. 22 is a diagram of a structure of yet another implementation of the structure shown in FIG. 14;
FIG. 23a is a diagram of a structure of a vapor chamber shown in FIG. 14 to FIG. 22 at another angle;
FIG. 23b is a diagram of a structure of still another implementation of the structure shown in FIG. 23a;
FIG. 24a is a diagram of a structure of yet another implementation of a structure shown in FIG. 4;
FIG. 24b is a diagram of a structure of an implementation of the structure shown in FIG. 24a at another angle;
FIG. 25 is a diagram of a structure of yet another implementation of a structure shown in FIG. 4 at a location B;
FIG. 26 is a diagram of an implementation of assembling a middle frame and a vapor chamber shown in FIG. 2;
FIG. 27a is a partial cross-sectional view of an implementation of a structure shown in FIG. 26 along a section line C-C;
FIG. 27b is an enlarged diagram of an implementation of the structure shown in FIG. 27a at a location D;
FIG. 28 is a diagram of another implementation of an electrical connection of a middle frame and a vapor chamber shown in FIG. 2;
FIG. 29 is a diagram of still another implementation of an electrical connection of a middle frame and a vapor chamber shown in FIG. 2;
FIG. 30 is a diagram of yet another implementation of an electrical connection of a middle frame and a vapor chamber shown in FIG. 2;
FIG. 31 is a diagram of a partial structure of another implementation of the electronic device shown in FIG. 1 along a line A-A;
FIG. 32 is an enlarged diagram of an implementation of the structure shown in FIG. 31 at a location E;
FIG. 33 is an enlarged diagram of another implementation of the structure shown in FIG. 31 at a location E; and
FIG. 34 is an enlarged diagram of still another implementation of the structure shown in FIG. 31 at a location E.

### DESCRIPTION OF EMBODIMENTS

The following describes embodiments of this application with reference to the accompanying drawings in embodiments of this application. Embodiments described with reference to the accompanying drawings in this specification are examples, and are intended to explain this application, but cannot be understood as a limitation on this application.

In the descriptions of embodiments of this application, it should be noted that terms "installation" and "connection" should be understood in a broad sense unless there is a clear stipulation and limitation. For example, "connection" may be a detachable connection, a nondetachable connection, a direct connection, or an indirect connection through an intermediate medium. It should be understood that, in this application, an "electrical connection" may be understood as physical contact and electrical conduction of components. It may also be understood as a form in which different components in a line structure are connected through physical lines that can transmit an electrical signal, such as a printed circuit board (printed circuit board, PCB) copper foil or a conducting wire. Both "connection" and "connected to" may indicate a mechanical connection relationship or a physical connection relationship, that is, a connection between A and B or that A is connected to B may indicate that there is a fastening component (like an adhesive, a welding layer, a screw, a bolt, or a rivet) between A and B, or A and B are in contact with each other and A and B are difficult to be separated.

In addition, "fastening" in this specification should also be understood in a broad sense. For example, "fastening" may be direct fastening or indirect fastening through an intermediate medium. "Fastening" means that two objects are connected to each other and a relative location relationship remains unchanged after the connection. The orientation terms mentioned in embodiments of this application, for example, "upper" and "lower", are merely directions with reference to the accompanying drawings. Therefore, the orientation terms are used to better and more clearly describe and understand embodiments of this application, rather than indicating or implying that an indicated apparatus or element needs to have a specific orientation or be constructed and operated in the specific orientation, and therefore cannot be construed as a limitation on embodiments of this application. "A plurality of" means two or more than two.

In the descriptions of embodiments of this application, unless otherwise specified, "/" indicates "or". For example, A/B may indicate A or B. "And/or" in this specification merely describes an association relationship for describing associated objects, and indicates that three relationships may exist. For example, A and/or B may indicate the following three cases: Only A exists, both A and B exist, and only B exists. In addition, in the descriptions of embodiments of this application, "a plurality of" means two or more.

In embodiments of this application, the terms "first", "second", "third", and "fourth" are merely intended for a purpose of description, and shall not be understood as an indication or implication of relative importance or an implicit indication of a quantity of indicated technical features. Therefore, a feature defined by "first", "second", "third", or "fourth" may explicitly or implicitly include one or more features.

In addition, limitations on relative location relationships, for example, being parallel, perpendicular, or aligned, are mentioned in embodiments of this application. These limitations are all defined based on a current technique level, but are not absolutely strict limitations. A small deviation is allowed, and being approximately parallel, approximately perpendicular, approximately aligned, or the like is allowed. For example, A being parallel to B means that A is parallel or approximately parallel to B, and an included angle of 0 degrees to 10 degrees between A and B is allowed. For example, A being perpendicular to B means that A is perpendicular or approximately perpendicular to B, and an included angle of 80 degrees to 100 degrees between A and B is allowed.

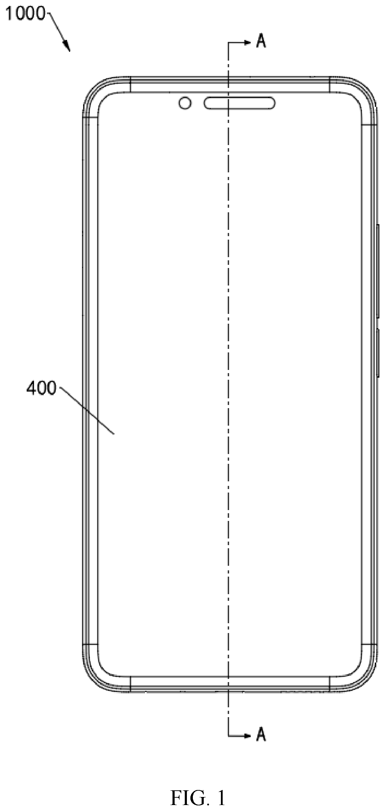

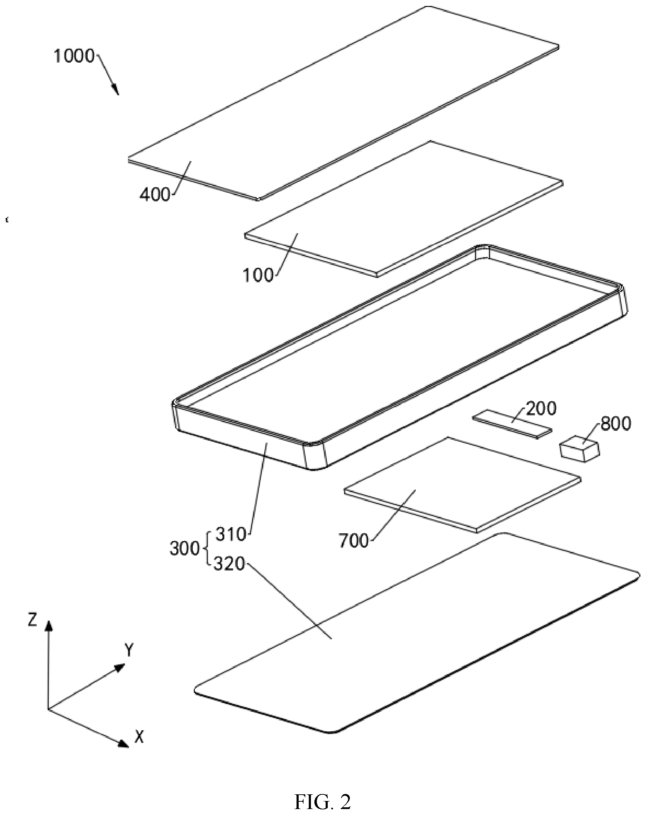

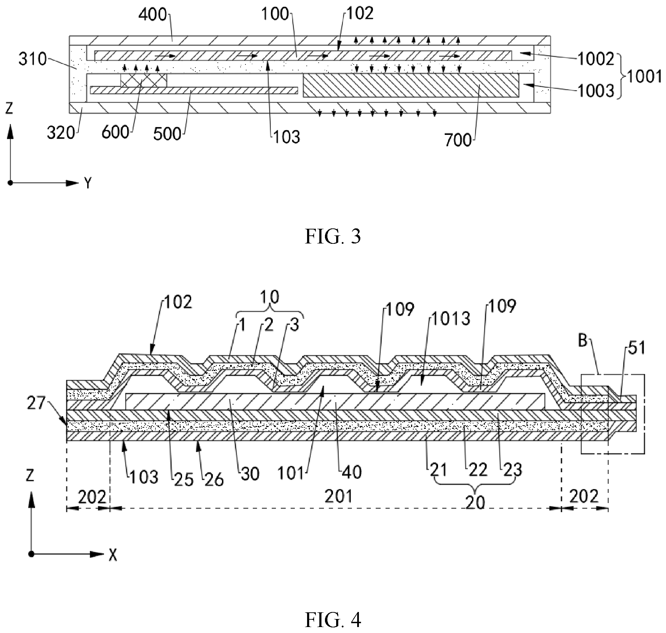

FIG. 1 is a diagram of a structure of an implementation of an electronic device 1000 according to an embodiment of this application. FIG. 2 is a partial exploded view of the electronic device 1000 shown in FIG. 1 according to an implementation. FIG. 3 is a diagram of a partial structure of the electronic device 1000 shown in FIG. 1 along a line A-A according to an implementation.

The electronic device 1000 may be a device, such as a mobile phone, a tablet personal computer (tablet personal computer), a laptop computer (laptop computer), a personal digital assistant (personal digital assistant, PDA), a camera, a personal computer, a notebook computer, a vehicle-mounted device, a video surveillance device, a wearable device, augmented reality (augmented reality, AR) glasses, an AR helmet, virtual reality (virtual reality, VR) glasses, or a VR helmet. It may be understood that the electronic device 1000 may be any electronic device 1000 that has a heat dissipation requirement. In the embodiment shown in FIG. 1, an example in which the electronic device 1000 is a mobile phone is used for description.

For example, the electronic device 1000 may include a vapor chamber 100, a heat emitting component 200, a housing 300, and a screen 400. The screen 400 is installed in the housing 300. The housing 300 and the screen 400 jointly enclose an accommodation space 1001 in the electronic device 1000. Both the vapor chamber 100 and the heat emitting component 200 are installed in the accommodation space 1001 of the electronic device 1000. It should be noted that FIG. 1, FIG. 2, FIG. 3, and related accompanying drawings in the following descriptions merely show some components included in the electronic device 1000 as an example. Actual shapes, actual sizes, actual locations, and actual structures of the components are not limited by FIG. 1, FIG. 2, FIG. 3, and the accompanying drawings in the following descriptions. In another embodiment, when the electronic device 1000 is a device in another form, the electronic device 1000 may not include the screen 400.

The screen 400 may be configured to display an image, a video, and the like. A touch sensing function of the screen 400 is used to sense a touch action of a user, to implement human-machine interaction. For example, the screen 400 may be a liquid crystal display (liquid crystal display, LCD), an organic light-emitting diode (organic light-emitting diode, OLED) display, an active matrix organic light-emitting diode or active matrix organic light-emitting diode (active-matrix organic light-emitting diode, AMOLED) display, a flexible light-emitting diode (flex light-emitting diode, FLED) screen 400, a mini-LED display, a micro-LED display, a micro-OLED display, or a quantum dot light-emitting diode (quantum dot light-emitting diode, QLED) display. The screen 400 may be a flat screen or a curved screen. The screen 400 may alternatively be a flexible display.

The housing 300 may be configured to protect an internal component (for example, a heat emitting component 200) of the electronic device 1000. For example, the housing 300 may include a middle frame 310 and a rear cover 320. The rear cover 320 is fastened to the middle frame 310. For example, the rear cover 320 may be fastened to the middle frame 310 by using an adhesive. Alternatively, the rear cover 320 and the middle frame 310 may be an integrally formed structure. In other words, the rear cover 320 and the middle frame 310 are an integral structure.

The rear cover 320 may be made of a metal material, or may be made of a glass material, or may be made of a plastic material, or may be made of a ceramic material. The rear cover 320 and the middle frame 310 may also be connected in a connection manner such as bonding, welding, a buckle connection, or a screw connection.

The screen 400 may be located on a side that is of the middle frame 310 and that is away from the rear cover 320. In this case, the screen 400 and the rear cover 320 are respectively located on two sides of the middle frame 310. The screen 400, a side frame, and the rear cover 320 jointly enclose an accommodation space 1001 of the electronic device 1000. For example, the middle frame 310 divides the accommodation space 1001 of the electronic device 1000 into a first space 1002 and a second space 1003. The middle frame 310 and the screen 400 enclose the first space 1002. The middle frame 310 and the rear cover 320 enclose the second space 1003.

In some implementations, components such as a camera module 800, a circuit board 500, a battery 700, a speaker, or a microphone may be further installed in the accommodation space 1001 of the electronic device 1000. The circuit board 500 may be a flexible circuit board 500, or may be a rigid circuit board 500. A power component such as a chip 600, a resistor, or a capacitor may be installed on the circuit board 500. Components such as the circuit board 500, the battery 700, the speaker, or the microphone may be separately installed in the first space 1002 and the second space 1003 according to an actual requirement.

For example, the heat emitting component 200 may be the chip 600 on the circuit board 500. The chip 600 may be a processing chip 600, a storage chip 600, or the like. Certainly, in some other embodiments, the heat emitting component 200 may alternatively be another power component in the electronic device 1000, for example, a power amplifier, a power management unit (power management unit, PMU), a power management unit, and a heat management unit. It may be understood that any component that generates heat when the electronic device 1000 runs may be the heat emitting component 200. In addition, there may be one, two, or more heat emitting components 200 in the electronic device 1000. When there are two or more heat emitting components 200, at least some of the heat emitting components 200 may be of a same type. For example, there may be two processing chips 600. For another example, there may be two storage chips 600.

When the heat emitting component 200 works, heat is generated, and a temperature at a location of the heat emitting component 200 in the electronic device 1000 is relatively high. As a result, the electronic device 1000 has a problem of being locally highly heated. The vapor chamber 100 is configured to transfer, to another location with a lower temperature in the electronic device 1000, heat generated when the heat emitting component 200 works. In some implementations, after the vapor chamber 100 transfers heat to another location with a lower temperature, the heat may be dissipated to an external space of the electronic device 1000 along the housing 300 and/or the screen 400. In other implementations, the vapor chamber 100 may also be referred to as a vapor chamber (vapor chamber, VC), a heat equalization plate, a heat guide plate, or the like.

In order that the vapor chamber 100 can more quickly transfer heat at a location of the heat emitting component 200 to another location with a lower temperature, the heat emitting component 200 should be disposed around the vapor chamber 100. For example, the heat emitting component 200 may be in direct contact with and be directly connected to the vapor chamber 100, or a heat conduction structure may be disposed between the heat emitting component 200 and the vapor chamber 100 to conduct, to the vapor chamber 100, heat generated by the heat emitting component 200. It may be understood that the heat emitting component 200 may be located in the first space 1002, or may be located in the second space 1003. When the electronic device 1000 includes a plurality of heat emitting components 200, a part of the heat emitting components 200 may be located in the first space 1002, and the other part of the heat emitting components 200 may be located in the second space 1003.

For example, the heat emitting component 200 is the chip 600, and the chip 600 is installed on the circuit board 500. In this case, the electronic device 1000 may further include the battery 700. The chip 600, the circuit board 500, and the battery 700 may all be installed in the second space 1003. The chip 600 is fastened to a side that is of the middle frame 310 and that faces the rear cover 320. The battery 700 may be fastened to a side that is of the middle frame 310 and that faces the rear cover 320, and is spaced from the chip 600. The vapor chamber 100 may be installed in the first space 1002. The vapor chamber 100 may be fastened to a side that is of the middle frame 310 and that faces the screen 400. It may be understood that the middle frame 310 may serve as a heat conduction structure. Heat generated when the chip 600 works may be conducted to the vapor chamber 100 through the middle frame 310. The middle frame 310 may also be used as a support member of the vapor chamber 100.

In some implementations, the middle frame 310 may be made of a material with a relatively high thermal conductivity coefficient, for example, a metal alloy material with high heat conductivity, such as aluminum, magnesium, titanium, copper, or stainless steel. In this way, the middle frame 310 can better conduct, to the vapor chamber 100, heat generated by the heat emitting component 200, and heat conduction efficiency is relatively high.

For example, the vapor chamber 100 and the middle frame 310 may be fastened in a form of pasting, edge-crossing welding, screw fastening, or the like.

For ease of description, a width direction of the vapor chamber 100 is defined as an X-axis. A length direction of the vapor chamber 100 is a Y-axis. A thickness direction of the vapor chamber 100 is a Z-axis. It may be understood that a coordinate system may be flexibly set according to a specific actual requirement.

FIG. 4 is a partial sectional view of the vapor chamber 100 shown in FIG. 3 at another angle according to an implementation.

As shown in FIG. 4, the vapor chamber 100 may include a first cover 10, a second cover 20, a capillary structure 30, a cooling medium 40, and a first conductive member 51. The first cover 10 may be fastened to the second cover 20, and enclose an accommodating cavity 101. The capillary structure 30 and the cooling medium 40 are located in the accommodating cavity 101.

As shown in FIG. 4, the first cover 10 may include a first conductive layer 1, a first insulation layer 2, and a second conductive layer 3 that are stacked. The first insulation layer 2 is connected between the first conductive layer 1 and the second conductive layer 3. The second conductive layer 3 is located on a side that is of the first insulation layer 2 and that is close to the second cover 20.

In some implementations, the first conductive layer 1 may be made of a conductive material. For example, the first conductive layer 1 may be a pure metal material or an alloy material, and a component of the first conductive layer 1 may include conductive metal such as gold, nickel, copper, iron, aluminum, titanium, magnesium, silver, and zinc. The first conductive layer 1 may also be a conductive ceramic material.

In some implementations, a resistivity of a material used for the first conductive layer 1 may be less than 10⁹ ohm-meters (Ωm). In this way, the first conductive layer 1 has relatively good conductivity.

In some implementations, the second conductive layer 3 may be made of a conductive material. For example, the second conductive layer 3 may be a pure metal material or an alloy material, and a component of the first conductive layer 1 may include conductive metal such as gold, nickel, copper, iron, aluminum, titanium, magnesium, silver, and zinc. The second conductive layer 3 may also be a conductive ceramic material. It may be understood that materials used for the first conductive layer 1 and the second conductive layer 3 may be the same or may be different. This is not limited in this application.

In some implementations, a resistivity of a material used for the second conductive layer 3 may be less than 10⁹ ohm-meters (Ωm). In this way, the second conductive layer 3 has relatively good conductivity.

In some implementations, the first insulation layer 2 may be made of an insulating material. For example, the first insulation layer 2 may be made of an organic polymer material, such as polyimide (Polyimide, PI), polypropylene (Polypropylene, PP), polytetrafluoroethylene (Polytetra fluoroethylene, PTFE), polyethylene terephthalate (Polyethylene terephthalate, PET), polyethylene naphthalate (Polyethylene Na phthalate, PEN), polydimethylsiloxane (polydimethylsiloxane, PDMS), polyethylene (polyethylene, PE), polypropylene carbonate (Polypropylene carbonate, PPC), polyvinyl chloride (polyviny chloride, PVC), polyvinylidene chloride (Polyvinylidene chloride, PVDC), polystyrene (Polystyrene, PS), and polyamide (Polyamide, PA). It may be understood that, compared with a metal material, the organic polymer material has a capability of resisting elastic-plastic deformation when being subject to force, and has a relatively high elongation rate. A capability of resisting deformation and fracture makes the first cover 10 easier to use a shaping process such as stamping or hot pressing.

In some implementations, a resistivity of a material used for the first insulation layer 2 may be greater than or equal to 10⁹ ohm-meters (Ωm).

In some implementations, both the first conductive layer 1 and the second conductive layer 3 may be made of a metal material. It may be understood that the metal material has a relatively large elastic modulus and relatively large hardness, and is not prone to deformation. The first conductive layer 1 and the second conductive layer 3 are made of the metal material, so that the first cover 10 has relatively large hardness and is not prone to deformation, to better protect the capillary structure 30 in the accommodating cavity 101.

In some implementations, density of the first insulation layer 2 may be less than density of the first conductive layer 1 and less than density of the second conductive layer 3. It may be understood that, in comparison with a solution in which the first cover 10 is all made of a conductive metal material, the first insulation layer 2 is made of a polymer insulating material to replace a part of a metal layer, to reduce average density of the first cover 10, thereby reducing overall mass of the vapor chamber 100 and facilitating lightening of the electronic device 1000.

It may be understood that the first insulation layer 2 is made of an organic polymer material. Because the organic polymer material has relatively large pores, long-term air tightness cannot be ensured by directly using the first cover 10 made of the organic polymer material. In this case, a vapor leakage problem may occur. In addition, the organic polymer material is in direct contact with the cooling medium 40 in the accommodating cavity 101. In this case, a chemical reaction easily occurs to generate a non-condensable gas. The non-condensable gas may accumulate in the accommodating cavity 101, resulting in degradation of thermal uniformity and heat dissipation performance. The first cover 10 in this application uses a three-layer structure including two conductive layers and one insulation layer sandwiched between the two conductive layers, and the second conductive layer 3 is in contact with the cooling medium 40. In one aspect, compared with a case in which the first cover 10 is all made of a metal material, the technical solution of this application can effectively reduce a total weight of the first cover 10, to implement a lightweight, flexible, and bendable design. In one aspect, when the solution of this application is compared with a solution in which only the first conductive layer 1 and the first insulation layer 2 are disposed on the first cover 10 or a solution in which the first cover 10 is all made of a polymer material, the first conductive layer 1 and the second conductive layer 3 may further implement sealing and protection on the first insulation layer 2, to prevent the first insulation layer 2 from being in direct contact with the cooling medium 40 to generate a gas. In addition, sealing reliability between the first cover 10 and the second cover 20 is relatively good.

In some implementations, the second cover 20 may include a third conductive layer 21, a second insulation layer 22, and a fourth conductive layer 23 that are stacked. The second insulation layer 22 is connected between the third conductive layer 21 and the fourth conductive layer 23. The fourth conductive layer 23 is connected between the second conductive layer 3 and the second insulation layer 22.

It may be understood that the second cover 20 uses a three-layer structure including two conductive layers and one insulation layer sandwiched between the two conductive layers, and the fourth conductive layer 23 is in contact with the cooling medium 40. This avoids a case of generating a gas when the second insulation layer 22 is in direct contact with the cooling medium 40, and sealing reliability between the first cover 10 and the second cover 20 is relatively good.

In some implementations, the third conductive layer 21 may be made of a conductive material. For example, the third conductive layer 21 may be a pure metal material or an alloy material, and a component of the first conductive layer 1 may include conductive metal such as gold, nickel, copper, iron, aluminum, titanium, magnesium, silver, and zinc. The third conductive layer 21 may also be made of a conductive ceramic material.

In some implementations, a resistivity of a material used for the third conductive layer 21 may be less than 10⁹ ohm-meters (Ωm). In this way, conductivity of the third conductive layer 21 is relatively good.

In some implementations, the fourth conductive layer 23 may be made of a conductive material. For example, the fourth conductive layer 23 may be a pure metal material or an alloy material, and a component of the first conductive layer 1 may include conductive metal such as gold, nickel, copper, iron, aluminum, titanium, magnesium, silver, and zinc. The fourth conductive layer 23 may also be a conductive ceramic material. It may be understood that a material used for the third conductive layer 21 may be the same as or different from a material used for the fourth conductive layer 23. This is not limited in this application.

In some implementations, a resistivity of a material used for the fourth conductive layer 23 may be less than 10⁹ ohm-meters (Ωm). In this way, the fourth conductive layer 23 has relatively good conductivity.

For example, the second insulation layer 22 may be made of an insulating material. For example, the second insulation layer 22 may be made of an organic polymer material, such as polyimide (Polyimide, PI), polypropylene (Polypropylene, PP), polytetrafluoroethylene (Polytetra fluoroethylene, PTFE), polyethylene terephthalate (Polyethylene terephthalate, PET), polyethylene naphthalate (Polyethylene Na phthalate, PEN), polydimethylsiloxane (polydimethylsiloxane, PDMS), polyethylene (polyethylene, PE), polypropylene carbonate (Polypropylene carbonate, PPC), polyvinyl chloride (polyviny chloride, PVC), polyvinylidene chloride (Polyvinylidene chloride, PVDC), polystyrene (Polystyrene, PS), and polyamide (Polyamide, PA). It may be understood that, compared with a metal material used for the entire second cover 20, the organic polymer material has a capability of resisting elastic-plastic deformation when being subject to force, and has a relatively high elongation rate. A capability of resisting deformation and fracture makes the second cover 20 easier to use a shaping process such as stamping or hot pressing. It may be understood that the material of the second insulation layer 22 may be the same as or different from that of the first insulation layer 2.

In some implementations, a resistivity of a material used for the second insulation layer 22 may be greater than or equal to 10⁹ ohm-meters (Ωm).

In some implementations, density of the second insulation layer 22 may be less than density of the third conductive layer 21 and less than density of the fourth conductive layer 23. It may be understood that, in comparison with a solution in which the second cover 20 is all made of a conductive metal material, the first insulation layer 2 is made of a polymer insulating material to replace a part of a metal layer, to reduce average density of the second cover 20, thereby reducing overall mass of the vapor chamber 100 and facilitating lightening of the electronic device 1000.

In some implementations, the material used for the first conductive layer 1, the material used for the second conductive layer 3, the material used for the third conductive layer 21, and the material used for the fourth conductive layer 23 may be the same. The material used for the first insulation layer 2 may be the same as the material used for the second insulation layer 22. For example, the material used for the first conductive layer 1, the material used for the second conductive layer 3, the material used for the third conductive layer 21, and the material used for the fourth conductive layer 23 may all be copper, and the material used for the first insulation layer 2 and the material used for the second insulation layer 22 may all be polyimide.

In other implementations, the second cover 20 may not be provided with the fourth conductive layer 23, and only the third conductive layer 21 and the second insulation layer 22. When the first cover 10 is fastened to the second cover 20, the second insulation layer 22 may be fastened between the third conductive layer 21 and the second conductive layer 3.

In other implementations, the second cover 20 may be made of a conductive material. It may be understood that the second cover 20 being made of the conductive material may include that the second cover 20 may be made of a conductive material at an entire layer, or the second cover 20 may include a plurality of layers of conductive materials.

For example, the second cover 20 may be all made of a conductive material. For example, the second cover 20 may be all made of a conductive metal material such as pure copper, a copper alloy, stainless steel, a titanium alloy, an aluminum alloy, a steel-copper composite material, or a titanium-copper alloy, or may be made of a conductive ceramic material.

For example, the second cover 20 may include a plurality of different conductive material layers. For example, the second cover 20 may include the third conductive layer 21 and the fourth conductive layer 23. The third conductive layer 21 and the fourth conductive layer 23 may be stacked in a first direction. The fourth conductive layer 23 is connected between the third conductive layer 21 and the second conductive layer 3. It may be understood that the material of the third conductive layer 21 may be the same as or different from the material of the fourth conductive layer 23.

In some implementations, hardness of the material used for the third conductive layer 21 may be greater than hardness of the material used for the fourth conductive layer 23. In this way, strength of the second cover 20 is better.

In other implementations, the second cover 20 may also include the third conductive layer 21, the fourth conductive layer 23, and a fifth conductive layer (not shown in the figure). The fifth conductive layer may be connected between the third conductive layer 21 and the fourth conductive layer 23.

For example, hardness of a material used for the fifth conductive layer may be greater than the hardness of the material used for the third conductive layer 21, and greater than the hardness of the material used for the fourth conductive layer 23. In this way, strength of the second cover 20 is better.

For example, the third conductive layer 21 and the fourth conductive layer 23 may be made of pure copper, and the fifth conductive layer may be made of a material such as steel, titanium, or aluminum.

It may be understood that, in the following embodiments, unless otherwise specified, description is provided by using an example in which the second cover 20 includes the third conductive layer 21, the fourth conductive layer 23, and the second insulation layer 22.

In other implementations, the second cover 20 may include a plurality of conductive layers and a plurality of insulation layers. A conductive layer farthest away from the accommodating cavity 101 in the plurality of conductive layers is the third conductive layer 21.

In some implementations, the second cover 20 includes a top surface 25, a bottom surface 26, and a side surface 27. The bottom surface 26 of the second cover 20 and the top surface 25 of the second cover 20 are disposed opposite to each other. The side surface 27 of the second cover 20 is connected between the top surface 25 of the second cover 20 and the bottom surface 26 of the second cover 20. The top surface 25 of the second cover 20 faces the accommodating cavity 101. The bottom surface 26 of the second cover 20 is a surface that is of the second cover 20 and that is away from the accommodating cavity 101.

For example, when the second cover 20 includes the third conductive layer 21, the fourth conductive layer 23, and the second insulation layer 22, a side surface 212 of the third conductive layer 21, a side surface 222 of the second insulation layer 22, and a side surface 232 of the fourth conductive layer 23 form the side surface 27 of the second cover 20. A surface that is of the third conductive layer 21 and that is away from the accommodating cavity 101 is the bottom surface 26 of the second cover 20. A surface that is of the fourth conductive layer 23 and that faces the accommodating cavity 101 forms the top surface 25 of the second cover 20.

As shown in FIG. 4, the first cover 10 may be fastened to the second cover 20, and enclose the accommodating cavity 101. For example, the second cover 20 may include an effective region 201 and an edge sealing region 202. The edge sealing region 202 may be connected to a peripheral edge of the effective region 201. A part of the first cover 10 is fastened to the edge sealing region 202 of the second cover 20, and a part of the first cover 10 is spaced from the effective region 201 of the second cover 20, to enclose the accommodating cavity 101. It may be understood that the effective region 201 may be configured to cooperate with the first cover 10, to enclose the accommodating cavity 101. The edge sealing region 202 may be configured to cooperate with the first cover 10, to implement sealing of the accommodating cavity 101.

For example, when the first cover 10 is fastened to the second cover 20, the second conductive layer 3 may be located on a side that is of the first insulation layer 2 and that is close to the second cover 20. The fourth conductive layer 23 may be located on a side that is of the second insulation layer 22 and that is close to the second conductive layer 3 of the first cover 10.

For example, a part of the second conductive layer 3 may be spaced from the fourth conductive layer 23 of the effective region 201, to enclose the accommodating cavity 101. A part of the second conductive layer 3 of the first cover 10 may be fastened to the fourth conductive layer 23 of the edge sealing region 202, to implement sealing of the accommodating cavity 101. In other implementations, the second conductive layer 3 may alternatively be all spaced from the fourth conductive layer 23 of the effective region 201, to enclose the accommodating cavity 101. In other words, the second conductive layer 3 does not participate in sealing of the accommodating cavity 101. In this case, a part of the first insulation layer 2 may be fastened to the fourth conductive layer 23 of the edge sealing region 202, to implement sealing of the accommodating cavity 101.

In other implementations, when the second cover 20 is not provided with the fourth conductive layer 23, a part of the second conductive layer 3 of the first cover 10 may be spaced from the second insulation layer 22 of the effective region 201, to enclose the accommodating cavity 101. The second conductive layer 3 of the first cover 10 may be fastened to the second insulation layer 22 of the edge sealing region 202, to implement sealing of the accommodating cavity 101.

For example, the first cover 10 may be fastened to the edge sealing region 202 of the second cover 20 in a welding manner. For example, the welding manner may be a welding process without requiring addition of solder, such as laser welding, diffusion welding, or ultrasonic welding; or may be a welding process requiring addition of solder. The solder may be a solder paste that includes a component such as tin, silver, or copper, or may be a material such as a hot melt adhesive. In other implementations, the first cover 10 may also be fastened to the edge sealing region 202 of the second cover 20 in an adhesive bonding manner.

In some implementations, when the first cover 10 is fastened to the second cover 20, electrical conduction may be implemented between the second conductive layer 3 and the fourth conductive layer 23 in a manner such as solder-free welding, welding by using a conductive solder, or bonding by using a conductive adhesive.

As shown in FIG. 3 and FIG. 4, when the vapor chamber 100 is fastened to the middle frame 310, the first cover 10 may be fastened to the middle frame 310, and the second cover 20 faces the screen 400; or the second cover 20 may be fastened to the middle frame 310, and the first cover 10 faces the screen 400. This is not limited in this application. The following provides description by using, as an example, an installation manner in which the second cover 20 is fastened to the middle frame 310 and the first cover 10 faces the screen 400.

In some implementations, the vapor chamber 100 may include a top surface 102 and a bottom surface 103 that are disposed opposite to each other. The top surface 102 is a surface on a side that is of the vapor chamber 100 and that faces the screen 400. The top surface 102 and the bottom surface 103 may be spaced in the thickness direction of the vapor chamber 100. For example, when the second cover 20 is fastened to the middle frame 310, a surface on a side that is of the first conductive layer 1 and that faces the screen 400 is the top surface 102 of the vapor chamber 100, and a surface that is of the second cover 20 and that faces the middle frame 310 is the bottom surface 103 of the vapor chamber 100. In other implementations, when the first conductive layer is fastened to the middle frame 310, a surface on a side that is of the second cover 20 and that faces the screen 400 is the top surface 102 of the vapor chamber 100, and a surface on a side that is of the first conductive layer 1 and that faces the middle frame 310 is the bottom surface 103 of the vapor chamber 100.

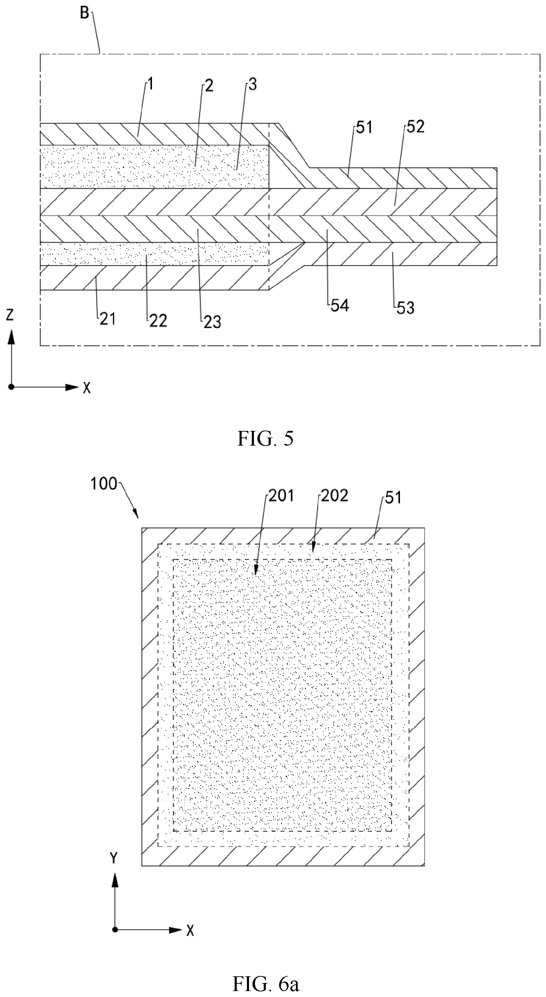

FIG. 5 is an enlarged diagram of the structure shown in FIG. 4 at a location B according to an implementation. For ease of understanding, in FIG. 5, schematic distinguishing is performed between the first conductive layer 1 and the first conductive member 51, between the second conductive layer 3 and the third conductive member 52, between the fourth conductive layer 23 and the fourth conductive member 54, and between the third conductive layer 21 and the second conductive member 53 by using dashed lines.

As shown in FIG. 4 and FIG. 5, a part of the first conductive member 51 is connected to the first conductive layer 1, and a part of the first conductive member 51 is connected to the second cover 20. It may be understood that the first conductive member 51 being connected to the second cover 20 may be that the first conductive member 51 is in direct contact with and connected to the second cover 20, or may be that the first conductive member 51 is indirectly connected to the second cover 20 by using another connection structure. A connection between the first conductive member 51 and the first conductive layer 1 may be a direct contact connection, or may be an indirect connection by using another connection structure.

For example, the vapor chamber 100 may include the first conductive member 51, the third conductive member 52, the fourth conductive member 54, and the second conductive member 53. A part of the first conductive member 51 may be fastened to the first conductive layer 1, and a part of the first conductive member 51 may be fastened to the third conductive member 52. The third conductive member 52 may be fastened between the first conductive member 51 and the fourth conductive member 54. The fourth conductive member 54 may be fastened between the third conductive member 52 and the second conductive member 53. In this way, the first conductive member 51 may be indirectly fastened to the third conductive layer 21 of the second cover 20 through the third conductive member 52, the fourth conductive member 54, and the second conductive member 53.

In some possible implementations, the first conductive member 51 and the first conductive layer 1 may be an integrally formed mechanical member. It may be understood that an integral mechanical member formed by two components through an integral forming process means that, in a process of forming one of the two components, the component is connected to the other component, and the two components can be connected together without reprocessing (for example, bonding, welding, a buckle connection, or a screw connection).

It may be understood that, compared with an externally connected independent conductive member, connection strength between the first conductive member 51 and the first conductive layer 1 is better. An independent conductive member means a conductive member prepared by using another process. Externally connected means that the conductive member is fastened to the first cover 10 and the second cover 20 in a connection manner such as welding or adhesive bonding.

For example, the first conductive layer 1 and the first conductive member 51 may be integrally formed by using a process such as metal pressing. In this way, the first conductive layer 1 and the first conductive member 51 may be directly electrically connected, and no additional electrical connection structure needs to be disposed.

In other implementations, the first conductive member 51 may also be an independent mechanical member. The independent mechanical member means that a process of preparing the mechanical member is an independent process, and the mechanical member is not formed by using a process shared with another mechanical member. For example, the first conductive member 51 may be fastened to the first conductive layer 1 and the third conductive member 52 by using a process such as adhesive bonding or welding.

In some possible implementations, the third conductive member 52 and the second conductive layer 3 may be an integrally formed mechanical member. In this way, connection strength between the third conductive member 52 and the second conductive layer 3 is better.

For example, the third conductive member 52 and the second conductive layer 3 may be integrally formed by using a process such as metal pressing. In this way, the third conductive member 52 and the second conductive layer 3 may be directly electrically connected, and no additional electrical connection structure needs to be disposed.

In some possible implementations, the fourth conductive member 54 and the fourth conductive layer 23 may be an integrally formed mechanical member. In this way, connection strength between the fourth conductive member 54 and the fourth conductive layer 23 is better.

For example, the fourth conductive member 54 and the fourth conductive layer 23 may be integrally formed by using a process such as metal pressing. In this way, the fourth conductive member 54 and the fourth conductive layer 23 may be directly electrically connected, and no additional electrical connection structure needs to be disposed.

In some possible implementations, the second conductive member 53 and the third conductive layer 21 may be an integrally formed mechanical member. Connection strength between the second conductive member 53 and the third conductive layer 21 is better.

For example, the second conductive member 53 and the third conductive layer 21 may be integrally formed by using a process such as metal pressing. In this way, the second conductive member 53 and the third conductive layer 21 may be directly electrically connected, and no additional electrical connection structure needs to be disposed.

For example, the first conductive member 51, the third conductive member 52, the fourth conductive member 54, and the second conductive member 53 may be fastened to each other in a welding manner. For example, the welding manner may be a welding process such as brazing, cold welding, pressure welding, diffusion welding, ultrasonic welding, or electromagnetic pulse welding. In other implementations, the first conductive member 51, the third conductive member 52, the fourth conductive member 54, and the second conductive member 53 may also be fastened in an adhesive bonding manner.

In some implementations, the first conductive member 51, the third conductive member 52, the fourth conductive member 54, and the second conductive member 53 may be arranged in a first direction. The first direction is a direction from the second cover 20 to the first cover 10. For example, in the accompanying drawings, an example in which the first direction is parallel to a Z-axis direction is used for illustration.

It may be understood that a stacking direction of the first conductive member 51, the third conductive member 52, the fourth conductive member 54, and the second conductive member 53 is consistent with a stacking direction of the first conductive layer 1, the second conductive layer 3, the third conductive layer 21, and the fourth conductive layer 23. When the first conductive member 51, the third conductive member 52, the fourth conductive member 54, and the second conductive member 53 are prepared through an integral forming process, a plate material for preparing the first cover 10 and the second cover 20 may be directly processed through press-fitting or by using a cutting tool, to remove an insulation layer in the plate material, thereby implementing fastening and electrical conduction of the first conductive member 51, the third conductive member 52, the fourth conductive member 54, and the second conductive member 53. The process is relatively simple.

In some implementations, the first conductive layer 1 may be electrically connected, through the first conductive member 51, to a surface that is of the second cover 20 and that is away from the accommodating cavity 101. In other words, the first conductive layer 1 may be electrically connected to the bottom surface 26 of the second cover 20 through the first conductive member 51. It may be understood that the first conductive member 51 may be in direct contact with and electrically connected to the bottom surface 26 of the second cover 20, or may be indirectly electrically connected to the bottom surface 26 of the second cover 20 through another conductive member.

For example, the first conductive member 51 is electrically connected between the first conductive layer 1 and the third conductive member 52. The third conductive member 52 is electrically connected between the first conductive member 51 and the fourth conductive member 54. The fourth conductive member 54 is electrically connected between the second conductive member 53 and the third conductive member 52. The second conductive member 53 is electrically connected to the third conductive layer 21. In this case, a surface that is of the third conductive layer 21 and that is away from the accommodating cavity 101 is the bottom surface 26 of the second cover 20. The first conductive layer 1 of the first cover 10 may be electrically connected to the bottom surface 26 of the second cover 20 through the first conductive member 51, the third conductive member 52, the fourth conductive member 54, and the second conductive member 53.

In other implementations, the first conductive member 51 may also be in direct contact with and electrically connected to the third conductive layer 21. Details are described below by using other embodiments. Details are not described herein again.

In some implementations, the electronic device 1000 may be provided with an electrical connection member to ground the first conductive layer 1 or the third conductive layer 21 of the vapor chamber 100.

It may be understood that stable conduction is implemented between the top surface 102 and the bottom surface 103 of the vapor chamber 100 by disposing the first conductive member 51. When unstable electrical conduction occurs between the top surface 102 and/or the bottom surface 103 of the vapor chamber 100 and the screen 400 of the electronic device 1000 or another electriferous structure in the electronic device 1000 in a process of using the electronic device 1000, regardless of whether an electrical connection member of the electronic device 1000 is electrically connected to the top surface 102 or the bottom surface 103 of the vapor chamber 100, the other one may be electrically connected to a ground location of the vapor chamber 100 through the first conductive member 51, to ensure stable grounding of the top surface 102 and the bottom surface 103 of the vapor chamber 100 and further lower a risk of generating a radiation spurious emission (radiated spurious emission, RSE) signal. A wireless communication signal of the electronic device 1000 is relatively good.

In some implementations, a minimum value of a resistance value between any point on the top surface 102 of the vapor chamber 100 and any point on the bottom surface 103 of the vapor chamber 100 may be less than 10¹⁵ ohms (Ω). For example, the resistance value between any point on the top surface 102 of the vapor chamber 100 and any point on the bottom surface 103 of the vapor chamber 100 may be less than 1000 Ω. The resistance value between any point on the top surface 102 and any point on the bottom surface 103 may be 0.05 Ω, 0.5 Ω, 1 Ω, 3 Ω, 5 Ω, 20 Ω, 200 Ω, 500 Ω, 700 Ω, or 999 Ω. In this case, the resistance value between the top surface 102 and the bottom surface 103 in an electrical connection state is relatively small.

For example, the resistance value between any point on the top surface 102 and any point on the bottom surface 103 may change based on different locations of selected points on the top surface 102 and the bottom surface 103, and the minimum value of the resistance value may be less than 10¹⁵ Ω, to ensure electrical conduction between the top surface 102 and the bottom surface 103.

For example, a manner of measuring the resistance value between any point on the top surface 102 and any point on the bottom surface 103 may include: using a multimeter to measure the resistance value, and contacting one of two probes of the multimeter with any point on the top surface 102 and contacting the other probe with any point on the bottom surface 103, to measure the resistance value.

In some implementations, the first conductive member 51 may be made of a conductive metal material. For example, the first conductive member 51 may be made of a material such as pure copper, a copper alloy, stainless steel, a titanium alloy, an aluminum alloy, a steel-copper composite material, or a titanium-copper alloy. It may be understood that, for material selection of the second conductive member 53, the third conductive member 52, and the fourth conductive member 54, reference may be made to material selection of the first conductive member 51. Details are not described herein again.

In some implementations, a forming process of the vapor chamber 100 may include: forming a plate material of a three-layer structure (conductive layer-insulation layer-conductive layer) through a press-fitting process, forming two plate materials into a specific shape through the press-fitting process to enclose the accommodating cavity 101, and then fastening peripheries of the two plate materials to form the to-be-processed vapor chamber 100. Because the first insulation layer 2 and the second insulation layer 22 are made of an organic polymer material, and hardness of the organic polymer material is less than that of a metal material or a conductive ceramic material, by setting a cutting angle direction of a cutting tool in a machining process, the cutting tool cuts a peripheral edge of the vapor chamber 100 in a direction at an included angle with the second cover 20, so that the two layers of polymer materials can be squeezed and partially cut to form the first conductive member 51, the first cover 10, and the second cover 20. It may be understood that a part of the organic polymer material at the insulation layer is removed through a cutting process, and a machining process is much simpler and has lower costs in comparison with a chemical etching or laser ablation process. The conductive layers with a part of the insulation layer removed are in contact with and connected to each other under extrusion of the cutting tool, to form relatively stable contact and implement electrical conduction. In this case, a connection process such as welding is not needed subsequently, thereby simplifying a process step.

It may be understood that the stacking direction of the first conductive member 51, the third conductive member 52, the fourth conductive member 54, and the second conductive member 53 may alternatively be set at an included angle with the first direction, for example, 3°, 10°, or 20°.

In some implementations, a forming process of the first conductive member 51, the third conductive member 52, the fourth conductive member 54, and the second conductive member 53 may include: forming a plate material of a three-layer structure (conductive layer-insulation layer-conductive layer) through a press-fitting process, forming two plate materials into a specific shape through the press-fitting process to enclose the accommodating cavity 101, and then fastening peripheries of the two plate materials to form the to-be-processed vapor chamber 100. The chemical etching or laser ablation process is performed on a side surface of the to-be-processed vapor chamber 100 to remove a part of the insulation layer, and the four conductive layers in a region with the insulation layer removed are tightly attached together through the press-fitting process to implement an electrical connection, thereby forming the first conductive member 51, the third conductive member 52, the fourth conductive member 54, and the second conductive member 53.

In other implementations, after the chemical etching or laser ablation process is performed, a conductive material (for example, a conductive adhesive, a coating, or a slurry) may also be filled at a location at which the insulation layer is removed, to implement the electrical connection between the layers. Alternatively, after the chemical etching or laser ablation process is performed, solder may be filled at the location at which the insulation layer is removed, and the welding process is performed, to implement fastening and electrical conduction between the first conductive member 51 and the third conductive member 52 and fastening and electrical conduction between the fourth conductive member 54 and the second conductive member 53.

In other implementations, when electrical conduction may be implemented between the second conductive layer 3 and the fourth conductive layer 23, the third conductive member 52 and the fourth conductive member 54 may not be in direct contact, but are indirectly fastened and electrically conducted through the second conductive layer 3 and the fourth conductive layer 23.

In other implementations, the vapor chamber 100 may not be provided with the fourth conductive member 54, the vapor chamber 100 may include the first conductive member 51, the third conductive member 52, and the second conductive member 53, and the second conductive member 53 is connected to a side that is of the third conductive member 52 and that is away from the first conductive member 51. The first conductive layer 1 may be electrically connected to the third conductive layer 21 through the first conductive member 51, the third conductive member 52, and the second conductive member 53.

In other implementations, the vapor chamber 100 may not be provided with the third conductive member 52, the vapor chamber 100 may include the first conductive member 51, the fourth conductive member 54, and the second conductive member 53, and the fourth conductive member 54 is connected between the first conductive member 51 and the second conductive member 53. The first conductive layer 1 may be electrically connected to the third conductive layer 21 through the first conductive member 51, the fourth conductive member 54, and the second conductive member 53.

In other implementations, the vapor chamber 100 may not be provided with the third conductive member 52 and the fourth conductive member 54. The first conductive layer 1 may be electrically connected to the third conductive layer 21 through the first conductive member 51 and the second conductive member 53. For example, the first conductive member 51 may be in direct contact with and connected to the second conductive member 53, and may be electrically connected to the second conductive member 53. Alternatively, when electrical conduction may be implemented between the second conductive layer 3 and the fourth conductive layer 23, the first conductive member 51 may be fastened to the second conductive layer 3 and the first conductive layer 1, and the second conductive member 53 may be fastened to the third conductive layer 21 and the fourth conductive layer 23. The first conductive layer 1 may be electrically connected to the third conductive layer 21 through the first conductive member 51, the second conductive layer 3, the fourth conductive layer 23, and the second conductive member 53.

In other implementations, when the second cover 20 is not provided with the fourth conductive layer 23, the vapor chamber 100 may not be provided with the fourth conductive member 54 either.

In other implementations, when the second cover 20 is all made of a conductive material, the vapor chamber 100 may not be provided with the fourth conductive member 54 either, and the second conductive member 53 and at least a part of the second cover 20 may be an integrally formed mechanical member. For example, when the second cover 20 includes a plurality of conductive layers, the second conductive member 53 and any one of the plurality of conductive layers may be an integrally formed mechanical member. For example, the second cover 20 includes the third conductive layer 21 and the fourth conductive layer 23. When the second insulation layer 22 is not disposed, the vapor chamber 100 may not be provided with the fourth conductive member 54. In this case, the third conductive layer 21 and the fourth conductive layer 23 may be electrically conducted; and the second conductive member 53 may be disposed at a same layer as the third conductive layer 21, or may be disposed at a same layer as the fourth conductive layer 23.

In other implementations, the second conductive member 53 may be an independent mechanical member, and the second conductive member 53 and the third conductive layer 21 may be fastened in a welding or adhesive bonding manner.

In other implementations, the third conductive member 52 may be an independent mechanical member, and the third conductive member 52 and the second conductive layer 3 may be fastened in a welding or adhesive bonding manner.

In other implementations, the fourth conductive member 54 may be an independent mechanical member, and the fourth conductive member 54 and the fourth conductive layer 23 may be fastened in a welding or adhesive bonding manner.

In some implementations, projections of the first conductive member 51, the third conductive member 52, the fourth conductive member 54, and the second conductive member 53 on a reference plane in the first direction overlap. The reference plane is a plane at which the first conductive layer 1 is located.

FIG. 6a is a diagram of the vapor chamber 100 shown in FIG. 4 at another angle according to an implementation. For ease of reading and understanding, in FIG. 6a, the effective region 201, the edge sealing region 202, and the first conductive member 51 are distinguished by using dashed lines and different filling patterns.

As shown in FIG. 4 and FIG. 6a, the first conductive member 51 may be located on a side that is of the edge sealing region 202 and that is away from the effective region 201. It may be understood that the first conductive member 51 is located on the side that is of the edge sealing region 202 and that is away from the effective region 201. This does not increase a thickness of the vapor chamber 100, and facilitates thinning of the electronic device 1000.

For example, the first conductive member 51 may be in a ring shape. The first conductive member 51 surrounds the edge sealing region 202 of the second cover 20. It may be understood that, in comparison with a solution in which the first conductive member 51 is located on one side of the edge sealing region 202 of the second cover 20, the first conductive member 51 may be in a ring shape in the solution shown in FIG. 6a. The first conductive member 51 surrounds the edge sealing region 202 of the second cover 20. A connection area between the first conductive member 51 and the first conductive layer 1 may be relatively large, and a connection area between the first conductive member 51 and the second cover 20 may also be relatively large. Connection strength between the first conductive member 51, and the first conductive layer 1 and the second cover 20 is better, and electrical connection stability therebetween is better.

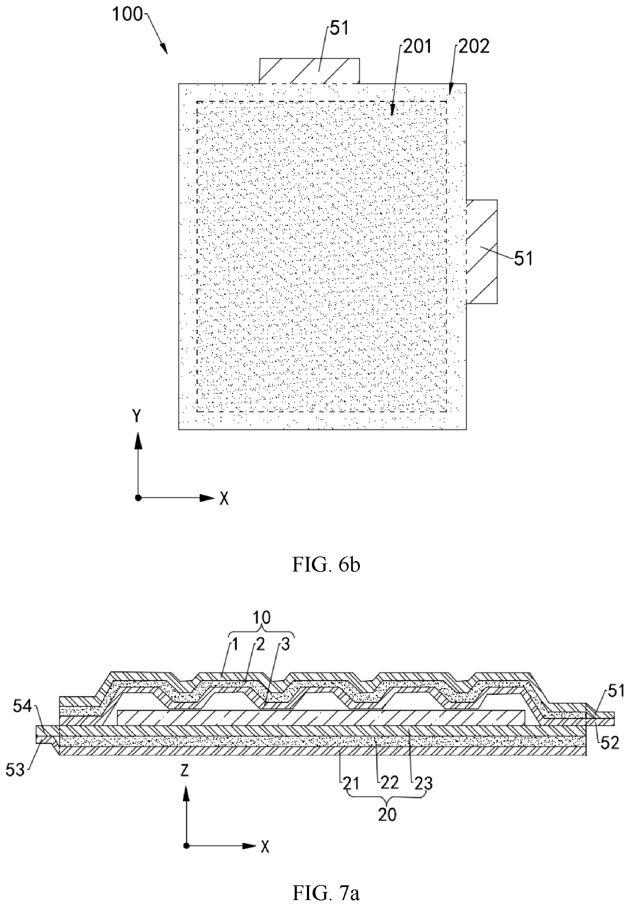

FIG. 6b is a diagram of the vapor chamber 100 shown in FIG. 4 at another angle according to another implementation. For ease of reading and understanding, in FIG. 6b, the effective region 201, the edge sealing region 202, and the first conductive member 51 are distinguished by using dashed lines and different filling patterns.

As shown in FIG. 4 and FIG. 6b, the first conductive member 51 may alternatively be located on a side that is of the edge sealing region 202 of the second cover 20 and that is away from the effective region 201. In this way, on an X-Y plane, the vapor chamber 100 occupies a relatively small area.

In some implementations, there may be a plurality of first conductive members 51. The plurality of first conductive members 51 are spaced. As shown in FIG. 6b, there are two first conductive members 51. One first conductive member 51 is located above the effective region 201, and the other first conductive member 51 is located on a right side of the effective region 201. In other implementations, there may be one first conductive member 51.

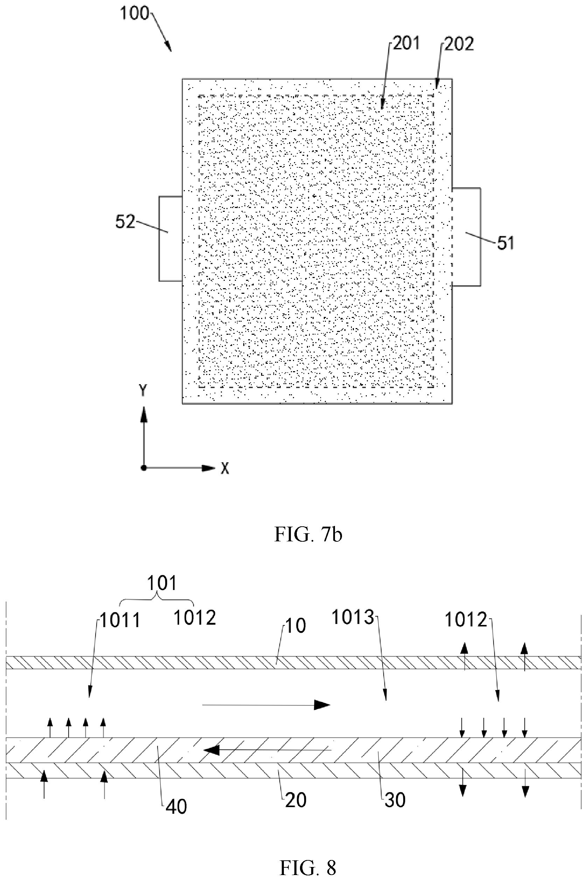

FIG. 7a is a diagram of a structure of the structure shown in FIG. 4 according to another implementation. FIG. 7b is a diagram of a structure of the structure shown in FIG. 7a at another angle according to an implementation.

As shown in FIG. 7a and FIG. 7b, a projection of the first conductive member 51 on the reference plane in the first direction and a projection of the second conductive member 53 on the reference plane in the first direction may be at least partially staggered. For example, the first direction may be parallel to the Z-axis direction.

It may be understood that, when a part of the second conductive layer 3 is fastened to the fourth conductive layer 23, electrical conduction may be implemented between the second conductive layer 3 and the fourth conductive layer 23. The first conductive member 51 may be electrically connected between the first conductive layer 1 and the second conductive layer 3 at a first location. The second conductive member 53 may be electrically connected between the third conductive layer 21 and the fourth conductive layer 23 at a second location. In this case, the first conductive layer 1 may be electrically connected to the third conductive layer 21 through the first conductive member 51, the second conductive layer 3, the fourth conductive layer 23, and the second conductive member 53. As shown in FIG. 7b, the first location may be located on a right side of the effective region 201, and the second location may be located on a left side of the effective region 201.

For example, the projection of the first conductive member 51 on the reference plane in the first direction and a projection of the third conductive member 52 on the reference plane in the first direction may overlap. A part of the first conductive member 51 may be fastened to the first conductive layer 1, and a part of the first conductive member 51 may be fastened to the third conductive member 52. A part of the third conductive member 52 may be fastened to the second conductive layer 3. The projection of the second conductive member 53 on the reference plane in the first direction and the projection of the fourth conductive member 54 on the reference plane in the first direction may overlap. A part of the second conductive member 53 may be fastened to the third conductive layer 21, and a part of the second conductive member 53 may be fastened to the fourth conductive member 54. A part of the fourth conductive member 54 may be fastened to the fourth conductive layer 23.

In this way, the first conductive layer 1 may be electrically connected to the second conductive layer 3 through the first conductive member 51 and the third conductive member 52. Electrical conduction may be implemented between the second conductive layer 3 and the fourth conductive layer 23. The fourth conductive layer 23 may be electrically connected to the third conductive layer 21 through the fourth conductive member 54 and the second conductive member 53. The first conductive layer 1 may be electrically connected to the third conductive layer 21 through the first conductive member 51, the third conductive member 52, the second conductive layer 3, the fourth conductive layer 23, the fourth conductive member 54, and the second conductive member 53.

It may be understood that the first conductive member 51 and the second conductive member 53 may be at different locations. When the first cover 10 and the second cover 20 are assembled, the first conductive member 51 and the second conductive member 53 do not need to be accurately positioned. The first conductive member 51 may be electrically connected to the second conductive member 53 through the second conductive layer 3 and the fourth conductive layer 23. Therefore, an assembly precision requirement is relatively low, and assembly difficulty is relatively low.

In some implementations, the first conductive member 51 and the second conductive member 53 may be spaced. In this way, when the first cover 10 and the second cover 20 are assembled, an assembly precision requirement is relatively low, and assembly difficulty is relatively low.

As shown in FIG. 3 and FIG. 4, the capillary structure 30 may be located in the accommodating cavity 101. For example, the capillary structure 30 may be located between the first cover 10 and the second cover 20, and may be fastened to the first cover 10 or the second cover 20. It may be understood that, in order that the cooling medium 40 absorbs heat more quickly, the capillary structure 30 may be disposed on a side that is in the accommodating cavity 101 and that is close to the heat emitting component 200. For example, when the first cover 10 is closer to the heat emitting component 200 than the second cover 20, the capillary structure 30 may be fastened to the first cover 10. When the second cover 20 is closer to the heat emitting component 200 than the first cover 10, the capillary structure 30 may be fastened to the second cover 20. For example, as shown in FIG. 3 and FIG. 4, when the vapor chamber 100 is installed in the first space 1002, the second cover 20 is fastened to the middle frame 310, and the heat emitting component 200 is disposed in the second space 1003 and fastened to a side that is of the middle frame 310 and that is away from the vapor chamber 100, the capillary structure 30 may be installed on the second cover 20. The capillary structure 30 is relatively close to the heat emitting component 200, and the cooling medium 40 in the capillary structure 30 can better absorb heat.

The meaning of the capillary structure 30 is as follows: Because a liquid surface of liquid has surface tension, when the liquid is infiltrated into a capillary hole, the liquid surface of the liquid is concave, so that the liquid surface exerts pull force on the liquid below, causing the liquid to move upward along a wall of the capillary hole. This causes a capillary phenomenon. The capillary structure 30 may include a plurality of capillary holes or a structure such as a fine groove similar to a capillary hole. In this way, after the cooling medium 40 enters the capillary hole or the fine groove in the capillary structure 30, the cooling medium 40 flows to the other end of the capillary hole under a capillary action, thereby completing transfer and return of the cooling medium 40.

For example, the capillary structure 30 may include one or more of a mesh structure, a straight line structure, a porous structure, a groove structure, or a channel structure.

The cooling medium 40 may be located in the accommodating cavity 101. The cooling medium 40 may be configured to conduct heat. For example, the cooling medium 40 may be pure water or alcohol.

FIG. 8 is a partial sectional view of the vapor chamber 100 shown in FIG. 3 according to an implementation. For ease of understanding, in FIG. 3 and FIG. 8, arrows indicate a heat transfer path and a movement path of the cooling medium 40.

As shown in FIG. 3 and FIG. 8, a volume of the accommodating cavity 101 is greater than a volume of the capillary structure 30. The accommodating cavity 101 may include a vapor channel 1013. It may be understood that, when the capillary structure 30 is located in the accommodating cavity 101, a remaining space of the accommodating cavity 101 except a space used for installing the capillary structure 30 may be used as the vapor channel 1013.

For example, when the vapor chamber 100 works, a part of the cooling medium 40 may be in a liquid state and located in the capillary structure 30, and the other half of the cooling medium 40 may be in a gas state and located in the vapor channel 1013.

For example, the accommodating cavity 101 may include a first region 1011 and a second region 1012. The first region 1011 is close to the heat emitting component 200 and has a relatively high temperature, and the second region 1012 is away from the heat emitting component 200 and has a relatively low temperature. The capillary structure 30 may extend from the first region 1011 to the second region 1012. The vapor channel 1013 may also extend from the first region 1011 to the second region 1012.

It may be understood that, when the vapor chamber 100 works, in the first region 1011, the cooling medium 40 in the capillary structure 30 vaporizes, and absorbs heat to change from the liquid state to the gas state. The gas-state cooling medium 40 moves in the vapor channel 1013 in a direction away from the heat emitting component 200, and moves to the second region 1012. The cooling medium 40 in the second region 1012 liquefies, and releases heat to change from the gas state to the liquid state. The cooling medium 40 (in the liquid state) generated through liquefaction enters the capillary structure 30, and flows back from the second region 1012 to the first region 1011 through the capillary structure 30. In this way, the cooling medium 40 can conduct, through a phase change cycle, heat generated by the heat emitting component 200 to another location with a lower temperature.

In some implementations, the accommodating cavity 101 may be in a vacuum environment. In the vacuum environment, a boiling point of the cooling medium 40 may be lower than that in a normal pressure environment. When a temperature near the heat emitting component 200 reaches the boiling point of the cooling medium 40, the cooling medium 40 vaporizes, and the vapor chamber 100 may start to work. It may be understood that, by setting the accommodating cavity 101 to the vacuum environment, an initial temperature at which the vapor chamber 100 works can be reduced. This avoids the following case: A temperature at the location of the heat emitting component 200 accumulates, and heat cannot be dissipated, causing an excessively high temperature at a local location, which affects working of another peripheral component.

In some implementations, a plurality of support columns 109 may be disposed on the first cover 10 and/or the second cover 20. For example, in the embodiment in FIG. 4, a plurality of support columns 109 are designed on an inner wall surface of the first cover 10. The support column may be configured to prevent the vapor chamber 100 from collapse. The vapor channel 1013 may be located between the support columns. The inner wall surface of the first cover 10 is a surface that is of the first cover 10 and that is configured to enclose the accommodating cavity 101.

The following specifically describes an implementation in which the vapor chamber 100 works in the electronic device 1000.

As shown in FIG. 3 and FIG. 8, for example, the heat emitting component 200 is the chip 600. When the chip 600 works, the chip 600 generates a large amount of heat, and a temperature at a location of the chip 600 is higher than heat at a location of the battery 700. The heat generated by the chip 600 is conducted to the first region 1011 of the accommodating cavity 101 through the middle frame 310 and the second cover 20 of the vapor chamber 100. The cooling medium in the capillary structure 30 at this location vaporizes quickly after absorbing heat, and absorbs a large amount of heat (latent heat of vaporization). The cooling medium 40 in a vapor form diffuses from a high pressure region (for example, the first region 1011) to a low pressure region (for example, the second region 1012) along the vapor channel 1013. The second region 1012 has a relatively low temperature. When the cooling medium 40 in the vapor form is in contact with the first cover 10 with a relatively low temperature, the cooling medium 40 quickly liquefies and emits a large amount of heat. The liquid cooling medium 40 formed through liquefaction in the second region 1012 passes through the capillary structure 30, and returns to the first region 1011 under an action of capillary force, thereby completing a heat conduction cycle. When the vapor chamber 100 works, a heat conduction cycle is continuously performed in the accommodating cavity 101 until a temperature of the first region 1011 can be close to a temperature of the second region 1012. In this way, risks of deteriorating performance of another component in the region, a shortened service life, the burnt screen 400, and a temperature affecting display effect due to a relatively high local temperature of the electronic device 1000 can be lowered.

For example, in the second region 1012, heat released by the cooling medium 40 may be dissipated from a display surface of the electronic device 1000 to the external space of the electronic device 1000 through a heat dissipation path: the first cover 10-the first space 1002-the screen 400. In addition, the heat released by the cooling medium 40 may be further dissipated from a rear surface of the electronic device 1000 to the external space of the electronic device 1000 through a heat dissipation path: the second cover 20-the middle frame 310-the second space 1003-the rear cover 320. In addition, the heat released by the cooling medium 40 may be further dissipated from a side surface of the electronic device 1000 to the external space of the electronic device 1000 through a heat dissipation path: the second cover 20-a side surface of the middle frame 310.

In some implementations, an equivalent thermal conductivity of the vapor chamber 100 may be greater than or equal to 2000 W/(m·°C). In this way, thermal conductivity of the vapor chamber 100 is relatively good. For example, the equivalent thermal conductivity of the vapor chamber 100 may be 2000 W/(m·°C), 3000 W/(m·°C), 4000 W/(m·°C), 5000 W/(m·°C), or 6000 W/(m·°C).

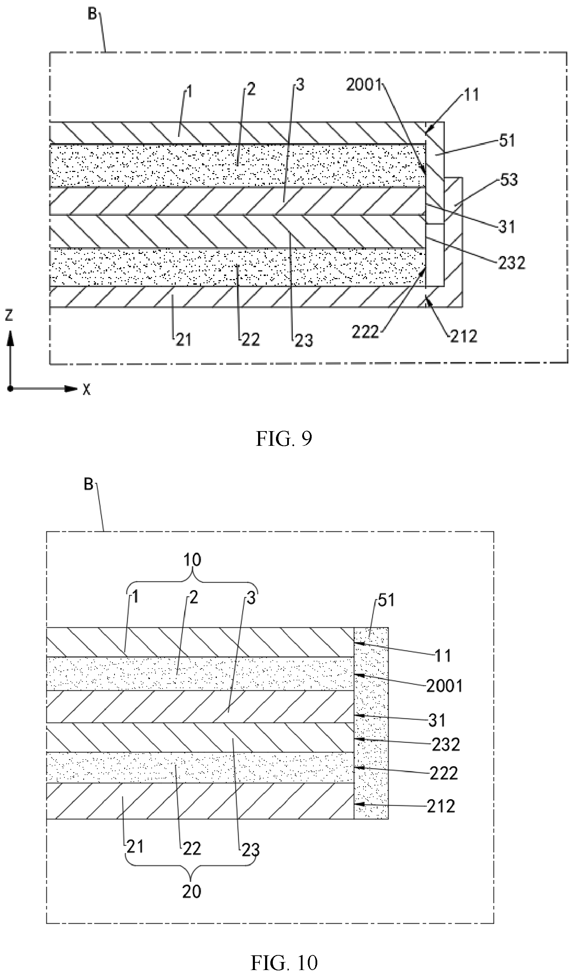

In some implementations, technical content that is the same as that of the vapor chamber 100 in the foregoing implementations is not described herein again. FIG. 9 is a diagram of a structure of the structure shown in FIG. 4 at a location B according to another implementation. For ease of understanding, in FIG. 9, schematic distinguishing is performed between the first conductive member 51 and the first conductive layer 1, and between the second conductive member 53 and the third conductive layer 21 by using dashed lines.

As shown in FIG. 4 and FIG. 9, the vapor chamber 100 may include the first conductive member 51 and the second conductive member 53. The first conductive member 51 is fastened to the second conductive member 53, and is electrically connected to the second conductive member 53. For example, the first conductive member 51 may be fastened to a side surface 11 of the first conductive layer 1 and a side surface 2001 of the first insulation layer 2. A part of the second conductive member 53 may be fastened to a side surface 212 of the third conductive layer 21, and a part of the second conductive member 53 may be fastened to a side that is of the first conductive member 51 and that is away from the accommodating cavity 101 (as shown in FIG. 4).

The first conductive member 51 may be electrically connected to the first conductive layer 1. A part of the second conductive member 53 may be electrically connected to the third conductive layer 21, and a part of the second conductive member 53 may be electrically connected to the first conductive member 51. In this way, the first conductive layer 1 may be electrically connected to the third conductive layer 21 of the second cover 20 through the first conductive member 51 and the second conductive member 53, thereby implementing electrical conduction between the top surface 102 and the bottom surface 103 of the vapor chamber 100.

It may be understood that, in a technical solution in which the second conductive member 53 and the first conductive member 51 are disposed opposite to each other in the Z-axis direction, and an end face of the second conductive member 53 is connected to an end face of the first conductive member 51, a connection area of the second conductive member 53 and the first conductive member 51 is limited by a smaller layer thickness of the first conductive layer 1 and the third conductive layer 21. In this embodiment, a part of the second conductive member 53 is connected to an outer side surface of the first conductive member 51, and the end faces of the two parts do not need to be aligned. A process is simple, manufacturing difficulty is low, and a product yield rate is relatively high. In addition, an upper limit of a connection area between the second conductive member 53 and the first conductive member 51 may be set to relatively large. For example, in the Z-axis direction, a maximum connection area length of the second conductive member 53 and the first conductive member 51 may reach a sum of a thickness of the first conductive layer 1, a thickness of the second conductive layer 3, a thickness of the first insulation layer 2, a thickness of the fourth conductive layer 23, and a thickness of the second insulation layer 22. The outer side surface of the first conductive member 51 is the surface that is of the first conductive member 51 and that is away from the accommodating cavity 101.

In addition, compared with the first conductive member 51 shown in FIG. 5, the conductive member in this embodiment may increase a larger electrical connection area when a width added to the vapor chamber 100 remains the same.

In some implementations, the first conductive member 51 may be further fastened to a side surface 31 of the second conductive layer 3, a side surface 232 of the fourth conductive layer 23, and a side surface 222 of the second insulation layer 22.

In some possible implementations, the first conductive member 51 and the first conductive layer 1 may be an integrally formed mechanical member. The second conductive member 53 and the third conductive layer 21 may be an integrally formed mechanical member. In this way, reliability of an electrical connection between the first conductive member 51 and the first conductive layer 1 is better. Reliability of an electrical connection between the second conductive member 53 and the third conductive layer 21 is better.

In some implementations, a forming process of the first conductive member 51 may include: forming a plate material of a three-layer structure (conductive layer-insulation layer-conductive layer) through a press-fitting process, forming two plate materials into a specific shape through the press-fitting process to enclose the accommodating cavity 101, and then fastening peripheries of the two plate materials to form the to-be-processed vapor chamber 100. The chemical etching or laser ablation process is performed on a side surface of the to-be-processed vapor chamber 100 to remove a part of the insulation layer and the conductive layer, and the remaining two conductive layers in a region with the insulation layer removed are tightly attached together through the press-fitting process to implement an electrical connection, thereby forming the first conductive member 51.

For example, electrical conduction may be implemented between the first conductive member 51 and the second conductive member 53 in a welding manner or a bonding manner by using a conductive adhesive.

In other implementations, the second conductive member 53 may be fastened to the side surface 212 of the third conductive layer 21 and the side surface 222 of the second insulation layer 22. A part of the first conductive member 51 may be fastened to the side surface 11 of the first conductive layer 1, and a part of the first conductive member 51 may be fastened to a side that is of the second conductive member 53 and that is away from the accommodating cavity 101 (as shown in FIG. 4).

In other implementations, when the second cover 20 is all made of a conductive material, the second conductive member 53 may be fastened to any location on a side surface of the second cover 20, and is electrically connected to the second cover. For example, the second conductive member 53 and at least a part of the second cover 20 may be an integrally formed mechanical member.

In some implementations, technical content that is the same as that of the vapor chamber 100 in the foregoing implementations is not described herein again. FIG. 10 is a diagram of a structure of the structure shown in FIG. 4 at a location B according to still another implementation.

As shown in FIG. 4 and FIG. 10, a part of the first conductive member 51 may be fastened to the side surface 11 of the first conductive layer 1, and a part of the first conductive member 51 may be fastened to the side surface 212 of the third conductive layer 21. The first conductive layer 1 may be electrically connected to the third conductive layer 21 through the first conductive member 51.

It may be understood that the first conductive member 51 is fastened to the side surface 11 of the first conductive layer 1 and the side surface 212 of the third conductive layer 21, without additionally increasing a thickness of the vapor chamber 100. This facilitates thinning of the vapor chamber 100, and is applicable to an electronic device 1000 with a relatively small thickness.

In some implementations, the first conductive member 51 may be fastened to the side surface 11 of the first conductive layer 1, the side surface 2001 of the first insulation layer 2, the side surface 31 of the second conductive layer 3, and the side surface 27 of the second cover 20. For example, the side surface 212 of the third conductive layer 21, the side surface 222 of the second insulation layer 22, and the side surface 232 of the fourth conductive layer 23 form the side surface of the second cover 20. The first conductive layer 1 may be fastened to the side surface 11 of the first conductive layer 1, the side surface 2001 of the first insulation layer 2, the side surface 31 of the second conductive layer 3, the side surface 212 of the third conductive layer 21, the side surface 222 of the second insulation layer 22, and the side surface 232 of the fourth conductive layer 23.

For example, the first conductive member 51 may be a conductive adhesive. It may be understood that the conductive adhesive has an electrical conduction capability and a bonding capability, the conductive adhesive is used as the first conductive member 51, and no fastening structure needs to be additionally disposed to fasten the first conductive member 51 to the side surface of the first cover 10 and the side surface of the second cover 20. A process is relatively simple.

For example, the first conductive member 51 may alternatively be a conductive metal layer formed through an electroplating process or a deposition process.

In other implementations, the first conductive member 51 may also be a structure made of a conductive material. For example, the first conductive member 51 may be a conductive metal structure or conductive foam. The first conductive member 51 may be fastened to the side surface of the first cover 10 and the side surface of the second cover 20 in a welding manner. The solder is a conductive material, so that the first conductive member 51 can be electrically connected to the first conductive layer 1 and the second cover 20. For another example, the first conductive member 51 may be fastened to the side surface of the first cover 10 and the side surface of the second cover 20 in a bonding manner by using a conductive adhesive.

In other possible implementations, the first conductive member 51 and the first conductive layer 1 may be an integrally formed mechanical member.

In other implementations, when the second cover 20 is all made of a conductive material, a part of the first conductive member 51 may be fastened to the side surface 11 of the first conductive layer 1, and a part of the first conductive member 51 may be fastened to any location on the side surface 27 of the second cover 20. The first conductive layer 1 may be electrically connected to the second cover 20 through the first conductive member 51.

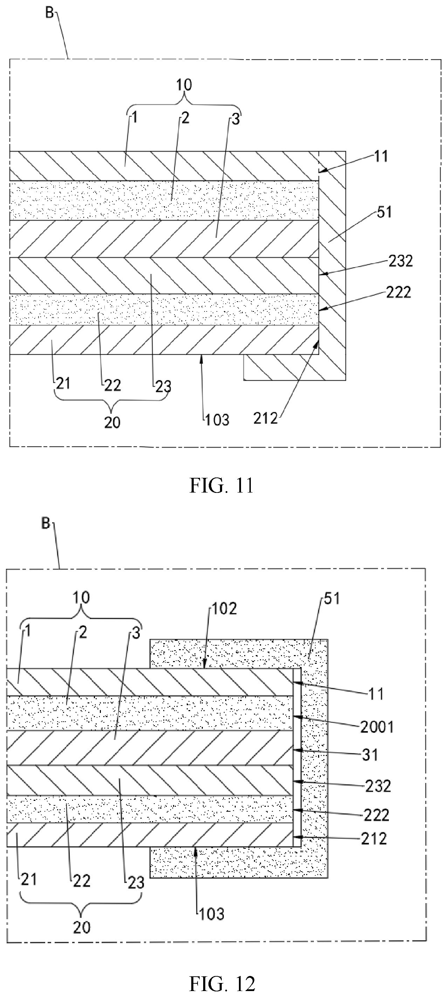

In some implementations, technical content that is the same as that of the vapor chamber 100 in the foregoing implementations is not described herein again. FIG. 11 is a diagram of a structure of the structure shown in FIG. 4 at a location B according to yet another implementation.

As shown in FIG. 4 and FIG. 11, a part of the first conductive member 51 may be fastened to the side surface 11 of the first conductive layer 1, and a part of the first conductive member 51 may be fastened to the surface that is of the second cover 20 and that is away from the accommodating cavity 101 (that is, the bottom surface 103 of the vapor chamber 100). The first conductive member 51 may be in an L shape. For example, a part of the first conductive member 51 may be fastened to the surface that is of the third conductive layer 21 and that is away from the accommodating cavity 101.

In this way, the first conductive layer 1 may be electrically connected to the bottom surface 103 of the vapor chamber 100 through the first conductive member 51, to implement electrical conduction between the top surface 102 and the bottom surface 103 of the vapor chamber 100.

It may be understood that, compared with a solution in which a part of the first conductive member 51 may be fastened to the side surface 11 of the first conductive layer 1, and a part of the first conductive member 51 may be fastened to the side surface 212 of the third conductive layer 21, in the solution of this embodiment, a part of the first conductive member 51 is fastened to the surface on a side (that is, the bottom surface 103) that is of the second cover 20 and that is away from the accommodating cavity 101, and is electrically connected to the second cover 20. An area of the bottom surface 103 is far greater than an area of the side surface 27 of the second cover 20. The connection area between the first conductive member 51 and the second cover 20 may be relatively large, connection difficulty is relatively low, and electrical connection reliability is relatively high.

In some possible implementations, the first conductive member 51 and the first conductive layer 1 may be an integrally formed mechanical member. In this way, connection strength between the first conductive member 51 and the first conductive layer 1 is better.

In some implementations, a preparation process of the vapor chamber 100 may include: When the plate material of the three-layer structure for preparing the first cover 10 is cut, a length of the plate material is reserved to prepare the first conductive member 51. The first conductive member 51 may be fastened between the first cover 10 and the second cover 20, and a redundant part of the second conductive layer 3 and the first insulation layer 2 may be removed through an etching or CNC cutting process, so that a layer length for forming the first conductive layer 1 is relatively large. After an excessive length and the second cover 20 are fastened to enclose the accommodating cavity 101, a shape of the first conductive member 51 is formed by using a process such as press-fitting.

For example, electrical conduction may be implemented between the first conductive member 51 and the third conductive layer 21 in a solder-free welding manner, a conductive solder welding manner, or a bonding manner by using a conductive adhesive.

In some implementations, when the second cover 20 is not provided with the second insulation layer 22, the side surface 212 of the third conductive layer 21 and the side surface 232 of the fourth conductive layer 23 form the side surface of the second cover 20.

In other implementations, a part of the first conductive member 51 may be fastened to a surface (that is, the top surface 102 of the vapor chamber 100) that is of the first conductive layer 1 and that is away from the accommodating cavity 101, and a part of the first conductive member 51 may be fastened to the side surface 212 of the third conductive layer 21. For example, the first conductive member 51 and the third conductive layer 21 may be an integrally formed mechanical member.

In other implementations, the first conductive member 51 may be an independent mechanical member. For example, the first conductive member 51 may be fastened to the first conductive layer 1 in a conductive solder welding manner or a bonding manner by using a conductive adhesive, and the first conductive member 51 and the first conductive layer 1 are electrically conducted.

In some implementations, technical content that is the same as that of the vapor chamber 100 in the foregoing implementations is not described herein again. FIG. 12 is a diagram of a structure of the structure shown in FIG. 4 at a location B according to yet another implementation.

As shown in FIG. 4 and FIG. 12, the first conductive member 51 may be an independent mechanical member. A part of the first conductive member 51 may be fastened to the first conductive layer 1, and a part of the first conductive member 51 may be fastened to the third conductive layer 21. For example, a part of the first conductive member 51 may be fastened to the surface that is of the first conductive layer 1 and that is away from the accommodating cavity 101 (that is, the top surface 102 of the vapor chamber 100), and a part of the first conductive member 51 may be fastened to the surface that is of the third conductive layer 21 and that is away from the accommodating cavity 101 (that is, the bottom surface 103 of the vapor chamber 100).

It may be understood that a part of the first conductive member 51 is fastened to the top surface 102 of the vapor chamber 100, and a part of the first conductive member 51 is fastened to the bottom surface 103 of the vapor chamber 100. In this embodiment, an electrical connection area between the first conductive member 51 and the first conductive layer 1 or between the first conductive member 51 and the second cover 20 is less limited, and a connection area between the first conductive member 51 and the first conductive layer 1 or the second cover 20 may be set to relatively large. This process is relatively simple, and electrical connection reliability is relatively good.

For example, the first conductive member 51 may be fastened to the first conductive layer 1 and the third conductive layer 21 in a solder-free welding manner or a conductive solder welding manner, and is electrically conducted with the first conductive layer 1 and the third conductive layer 21. In other implementations, the first conductive member 51 may be fastened to the first conductive layer 1 and the second cover 20 in a bonding manner by using a conductive adhesive. It may be understood that, in comparison with an integral forming solution, in this embodiment, a process of a solution of externally connecting the first conductive member 51 is simpler, and costs of the process are lower.

In some implementations, a preparation process of the vapor chamber 100 may include: first preparing the first conductive member 51, and then fastening the first conductive member 51 to the first conductive layer 1 and the third conductive layer 21 in a welding manner or an adhesive bonding manner.

In some implementations, the first conductive member 51 may also be spaced (as shown in FIG. 12) from the side surface 11 of the first conductive layer 1, the side surface 31 of the second conductive layer 3, the side surface 2001 of the first insulation layer 2, the side surface 212 of the third conductive layer 21, the side surface 222 of the second insulation layer 22, and the side surface 232 of the fourth conductive layer 23. In other implementations, the first conductive member 51 may also be in direct contact with and fastened to one or more of the side surface 11 of the first conductive layer 1, the side surface 31 of the second conductive layer 3, the side surface 2001 of the first insulation layer 2, the side surface 212 of the third conductive layer 21, the side surface 222 of the second insulation layer 22, and the side surface 232 of the fourth conductive layer 23. In this way, areas of fastening between the first conductive member 51 and the first cover 10 and between the first conductive member 51 and the second cover 20 are relatively large, and connection stability is better.

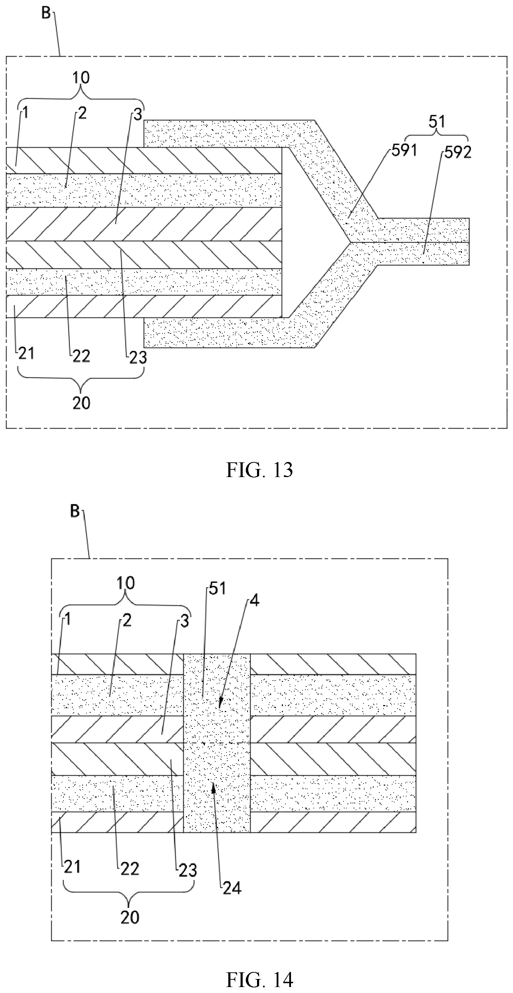

FIG. 13 is a diagram of a structure of the structure shown in FIG. 12 according to still another implementation.

As shown in FIG. 13, the first conductive member 51 may include a first submember 591 and a second submember 592. A part of the first submember 591 may be fastened to the top surface 102 of the vapor chamber 100, and a part of the first submember 591 may be fastened to the second submember 592. A part of the second submember 592 may be fastened to the bottom surface 103 of the vapor chamber 100. For example, a part of the first submember 591 may be fastened to the surface on a side that is of the first conductive layer 1 and that is away from the accommodating cavity 101, and a part of the first submember 591 may be fastened to the second submember 592; and a part of the second submember 592 may be fastened to a surface that is of the third conductive layer 21 and that is away from the accommodating cavity 101. The first conductive layer 1 may be electrically connected to the bottom surface 103 of the vapor chamber 100 through the first submember 591 and the second submember 592.

It may be understood that, in this embodiment, the first conductive member 51 may have a free end (that is, a part connected to the first submember 591 and the second submember 592) that extends out. When the vapor chamber 100 is installed on the electronic device 1000, the free end may be longer to be directly connected to the middle frame 310 or the screen 400, to implement an electrical connection. In other words, when the free end of the first conductive member 51 is long enough, the vapor chamber 100 may be electrically connected to the screen 400 or the vapor chamber 100 may be electrically connected to the middle frame 310 at a place away from the vapor chamber 100.

In some implementations, a length of a part that is of the first submember 591 and that is on an outer side of the side surface 11 of the first conductive layer 1 in the X-axis direction is greater than a thickness of the first submember 591 in the Z-axis direction. The outer side of the side surface 11 of the first conductive layer 1 is a side that is of the side surface 11 and that is away from the accommodating cavity 101.

In some implementations, a length of a part that is of the second submember 592 and that is on an outer side of the side surface 212 of the third conductive layer 21 in the X-axis direction is greater than a thickness of the second submember 592 in the Z-axis direction. The outer side of the side surface 212 is a side that is of the side surface 212 and that is away from the accommodating cavity 101 (as shown in FIG. 4).

In some implementations, the first submember 591 and the second submember 592 may be two independent mechanical members. In other words, the first submember 591 and the second submember 592 may be separately prepared by using different processes.

In some implementations, a preparation process of the vapor chamber 100 may include: separately preparing the first submember 591 and the second submember 592, and then fastening a part of the first submember 591 to a side that is of the first conductive layer 1 and that is away from the first insulation layer 2. A part of the second submember 592 is fastened to a side that is of the second cover 20 and that is away from the second conductive layer 3, and then the first submember 591 and the second submember 592 are connected. Alternatively, the first submember 591 and the second submember 592 are first connected to form the first conductive member 51, and then the first submember 591 and the second submember 592 are respectively fastened to the first conductive layer 1 and the second cover 20.

For example, the first submember 591 and the second submember 592 may be fastened and electrically conducted in a press-fitting or welding process.

In other implementations, the first submember 591 and the second submember 592 may alternatively be an integrally formed mechanical member. It may be understood that, when the first submember 591 and the second submember 592 are an integrally formed mechanical member, a free end may be formed by using a folding or cutting process.

It may be understood that the first conductive member 51 shown in FIG. 12 and FIG. 13 is not affected by a layer structure of the second cover 20, and electrical conduction may be implemented between the first conductive layer 1 and the bottom surface 103 of the vapor chamber 100 by using the first conductive member 51.

In some implementations, technical content that is the same as that of the vapor chamber 100 in the foregoing implementations is not described herein again. FIG. 14 is a diagram of a structure of the structure shown in FIG. 4 at a location B according to yet another implementation.

As shown in FIG. 14, the first cover 10 may be provided with a first through hole 4, and the first through hole 4 may penetrate the first conductive layer 1, the first insulation layer 2, and the second conductive layer 3. The edge sealing region 202 of the second cover 20 may be provided with a second through hole 24 (for ease of understanding, the first through hole 4 and the second through hole 24 are schematically distinguished by using dashed lines in FIG. 14). The second through hole 24 may penetrate the second cover 20. The first through hole 4 is connected to the second through hole 24. For example, when the second cover 20 includes the third conductive layer 21, the fourth conductive layer 23, and the second insulation layer 22, the second through hole 24 penetrates the third conductive layer 21, the fourth conductive layer 23, and the second insulation layer 22.

For example, the first through hole 4 and the accommodating cavity 101 are spaced, and the first through hole 4 communicates with the second through hole 24. A part of the first conductive member 51 is located in the first through hole 4, and a part of the first conductive member 51 is located in the second through hole 24. One end of the first conductive member 51 is fastened to the first conductive layer 1, and the other end of the first conductive member 51 is fastened to the third conductive layer 21. One end of the first conductive member 51 is electrically connected to the first conductive layer 1, and the other end of the first conductive member 51 is electrically connected to the third conductive layer 21. It may be understood that, in a manner of providing a through hole, the first conductive member 51 is located in the first through hole 4 and the second through hole 24, the first conductive member 51 is not prone to fall out of the first through hole 4 and the second through hole 24, and reliability of an electrical connection between the first conductive layer 1 and the second cover 20 is relatively good.

In some implementations, the first conductive member 51 may be of a solid structure, and is filled in the first through hole 4 and the second through hole 24. In this way, strength of the first conductive member 51 is better, and stability of an electrical connection between the first conductive layer 1 and the second cover 20 is better.

For example, the first through hole 4 may be prepared by using a mechanical drilling process, a laser drilling process, or a chemical etching process.

For example, the second through hole 24 may also be prepared by using a mechanical drilling process, a laser drilling process, or a chemical etching process.

For example, the first conductive member 51 may be a conductive metal layer formed by using a deposition process, or may be filled with a conductive slurry. It may be understood that the conductive slurry or the conductive metal layer formed by using the deposition process can better adapt to a shape of a through hole, and better cover hole walls of the first through hole 4 and the second through hole 24. Electrical connections between the first conductive layer 1 and the second cover 20 and between the first conductive member 51 and each of the first conductive layer 1 and the third conductive layer 21 are better, and stability of an electrical connection between the top surface 102 and the bottom surface 103 of the vapor chamber 100 is better.

In some implementations, when the first conductive member 51 is formed by using the deposition process, a pad may be placed on a side that is of the second cover 20 and that is away from the second conductive layer 3. The pad may be configured to seal an opening of the second through hole 24 at a surface on the side that is of the second cover 20 and that is away from the second conductive layer 3, to avoid leakage of deposited metal.

In other implementations, the second through hole 24 may not penetrate the fourth conductive layer 23. The first conductive layer 1 may be electrically connected to the third conductive layer 21 through the first conductive member 51 and the fourth conductive layer 23.

In other implementations, the first conductive member 51 may alternatively be a conductive material such as conductive foam or conductive rubber.

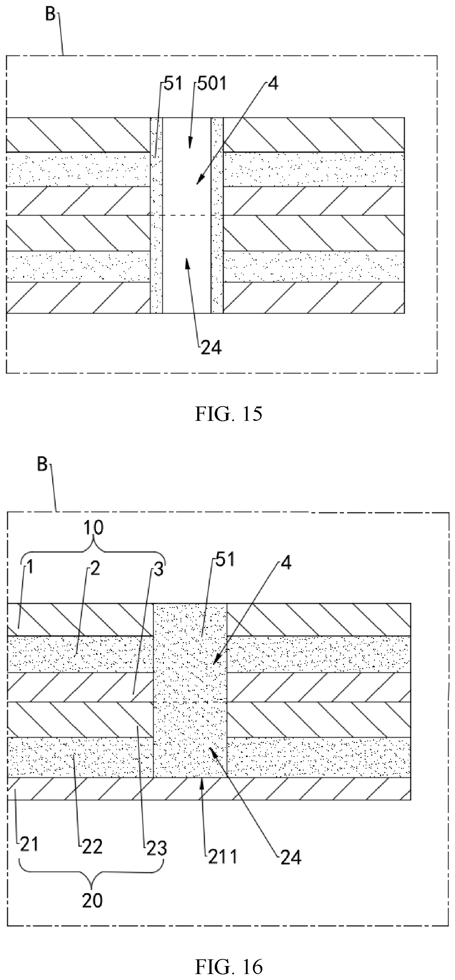

FIG. 15 is a diagram of a structure of the structure shown in FIG. 14 according to still another implementation. For ease of understanding, in FIG. 15, the first through hole 4 and the second through hole 24 are schematically distinguished by using dashed lines.

As shown in FIG. 15, the first conductive member 51 may alternatively be of a hollow-out structure. For example, the first conductive member 51 may have a cavity 501, and the cavity 501 is spaced from a wall surface of the first through hole 4 and a wall surface of the second through hole 24. It may be understood that, compared with the first conductive member 51 of a solid structure in a solution, the first conductive member 51 in this embodiment is of a hollow-out structure and has lower material costs, and the first conductive member 51 has a smaller weight. This facilitates lightening of the vapor chamber 100. It may be understood that structures of the first through hole 4, the second through hole 24, and the first conductive member 51 shown in FIG. 14 and FIG. 15 do not limit a layer structure of the second cover 20; the second cover 20 may be of any layer structure; and the second cover 20 may include the second insulation layer 22, or may not include the second insulation layer 22 and be all made of a conductive material.

FIG. 16 is a diagram of a structure of the structure shown in FIG. 14 according to another implementation. For ease of understanding, in FIG. 16, the first through hole 4 and the second through hole 24 are schematically distinguished by using dashed lines.

As shown in FIG. 4 and FIG. 16, the second through hole 24 may alternatively not penetrate the third conductive layer 21. In this case, the second through hole 24 penetrates only the fourth conductive layer 23 and the second insulation layer 22. The top surface 211 of the third conductive layer 21 is exposed from the second through hole 24. The top surface 211 of the third conductive layer 21 is a surface on a side that is of the third conductive layer 21 and that faces the accommodating cavity 101.

It may be understood that, in comparison with the structure shown in FIG. 14, in this embodiment, the top surface 211 of the third conductive layer 21 is exposed from the second through hole 24, and the first conductive member 51 may be fastened to the top surface 211 of the third conductive layer 21 and be electrically connected to the third conductive layer 21. A connection area between the first conductive member 51 and the third conductive layer 21 is relatively large, and reliability of an electrical connection between the first conductive member 51 and the third conductive layer 21 is relatively good.

In addition, when the first conductive member 51 is installed in the first through hole 4 and the second through hole 24, the third conductive layer 21 may be configured to serve as a pad for sealing one end of the second through hole 24, and the first conductive member 51 may be installed in the first through hole 4 and the second through hole 24 from an opening of the first through hole 4 on the first conductive layer 1. This does not require to additionally dispose a sealing mold.

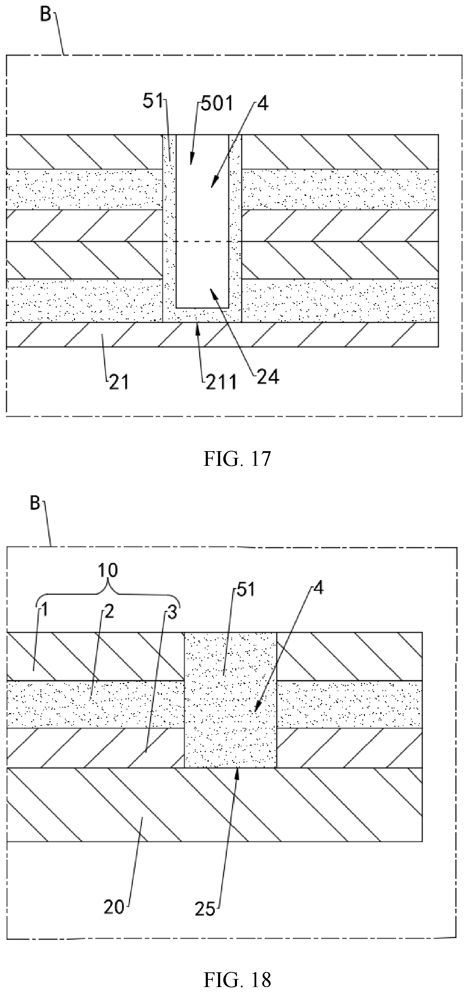

FIG. 17 is a diagram of a structure of the structure shown in FIG. 16 according to still another implementation. For ease of understanding, in FIG. 17, the first through hole 4 and the second through hole 24 are schematically distinguished by using dashed lines.

As shown in FIG. 17, the first conductive member 51 may be of a hollow-out structure. For example, the first conductive member 51 may have the cavity 501, and the cavity 501 is spaced from the wall surface of the first through hole 4, the wall surface of the second through hole 24, and the top surface 211 of the third conductive layer 21. The first conductive member 51 may be fastened to the wall surface of the first through hole 4, the wall surface of the second through hole 24, and the top surface 211 of the third conductive layer 21. In this way, the first conductive member 51 is electrically connected to the first conductive layer 1 and the third conductive layer 21. It may be understood that, in comparison with the structure of the first conductive member 51 shown in FIG. 15, in this embodiment, the connection area between the first conductive member 51 and the third conductive layer 21 is larger, and the connection strength between the first conductive member 51 and the second cover 20 is better. In comparison with the structure of the first conductive member 51 shown in FIG. 16, in this embodiment, the first conductive member 51 also requires fewer materials and has lower material costs, and mass of the vapor chamber 100 is smaller, thereby facilitating lightening of the vapor chamber 100.

In other implementations, the third conductive layer 21 may also be exposed from the cavity 501.

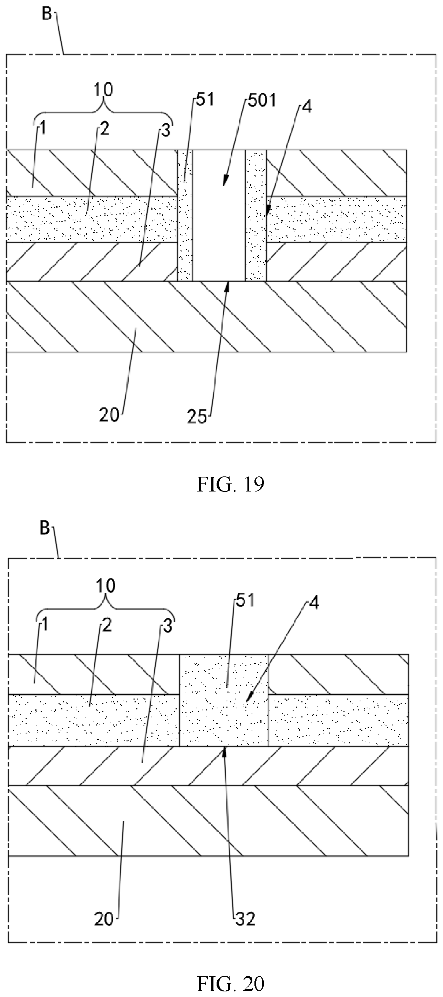

FIG. 18 is a diagram of a structure of the structure shown in FIG. 14 according to still another implementation. FIG. 19 is a diagram of a structure of the structure shown in FIG. 18 according to still another implementation.

As shown in FIG. 18 and FIG. 19, when the second cover 20 is all made of a conductive material, the second cover 20 may not be provided with the second through hole 24. For example, the first cover 10 may be provided with the first through hole 4, and the first through hole 4 may penetrate the first conductive layer 1, the second conductive layer 3, and the first insulation layer 2. The top surface 25 of the second cover 20 is exposed from the first through hole 4. The first conductive member 51 is located in the first through hole 4. One end of the first conductive member 51 is fastened to the first conductive layer 1, and the other end of the first conductive member 51 is fastened to the top surface 25 of the second cover 20. One end of the first conductive member 51 is electrically connected to the first conductive layer 1, and the other end of the first conductive member 51 is electrically connected to the second cover 20. In this way, the first conductive layer 1 may be electrically connected to the top surface 25 of the second cover 20 through the first conductive member 51.

In some implementations, the first conductive member 51 may be of a hollow-out structure. For example, the first conductive member 51 may have the cavity 501, and the cavity 501 is spaced from the wall surface of the first through hole 4 and the top surface 25 of the second cover 20.

In other implementations, when the second cover 20 is all made of a conductive material, the second through hole 24 may alternatively penetrate all or a part of the second cover 20.

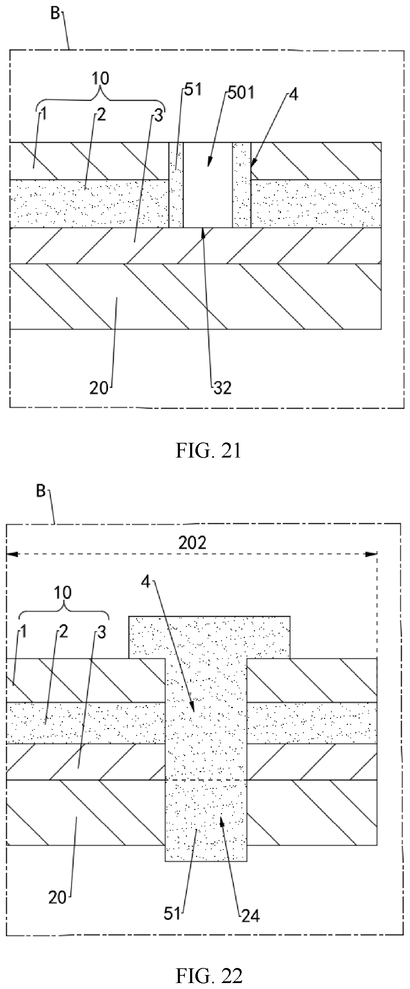

FIG. 20 is a diagram of a structure of the structure shown in FIG. 18 according to still another implementation. FIG. 21 is a diagram of a structure of the structure shown in FIG. 19 according to still another implementation.

As shown in FIG. 20 and FIG. 21, the second cover 20 is all made of a conductive material. The second cover 20 may not be provided with the second through hole 24. The first through hole 4 may not penetrate the second conductive layer 3. For example, the first through hole 4 may penetrate the first conductive layer 1 and the first insulation layer 2. The top surface 32 of the second conductive layer 3 may be exposed from the first through hole 4. The top surface 32 of the second conductive layer 3 is a surface on a side that is of the second conductive layer 3 and that is away from the second cover 20. The first conductive member 51 may be located in the first through hole 4. One end of the first conductive member 51 is fastened to the first conductive layer 1, and the other end of the first conductive member 51 is fastened to the second conductive layer 3. The second conductive layer 3 is electrically connected to the second cover 20. One end of the first conductive member 51 is electrically connected to the first conductive layer 1, and the other end of the first conductive member 51 is electrically connected to the second conductive layer 3. In this way, the first conductive layer 1 may be electrically connected to the second cover 20 through the first conductive member 51 and the second conductive layer 3.

For example, the first conductive member 51 may be solid (as shown in FIG. 20), or may be hollow (as shown in FIG. 21).

For example, when the first conductive member 51 is hollow, the first conductive member 51 may have the cavity 501, the cavity 501 is spaced from the wall surface of the first through hole 4, and the top surface 32 of the second conductive layer 3 is exposed from the cavity 501.

FIG. 22 is a diagram of a structure of the structure shown in FIG. 14 according to yet another implementation. For ease of understanding, in FIG. 22, the first through hole 4 and the second through hole 24 are schematically distinguished by using dashed lines.

As shown in FIG. 22, the first conductive member 51 may be a screw or a bolt. The first cover 10 is provided with the first through hole 4. The first through hole 4 penetrates the first conductive layer 1, the first insulation layer 2, and the second conductive layer 3. The edge sealing region 202 of the second cover 20 may be provided with the second through hole 24. The second through hole 24 may penetrate the second cover 20. A part of the first conductive member 51 is located in the first through hole 4, and a part of the first conductive member 51 is located in the second through hole 24. The first conductive member 51 is fastened to the hole wall of the first through hole 4 and the hole wall of the second through hole 24. A part of the first conductive member 51 is electrically connected to the first conductive layer 1, and a part of the first conductive member 51 is electrically connected to the second cover 20. The first conductive layer 1 may be electrically connected to the second cover 20 through the first conductive member 51.

It may be understood that the first conductive member 51 is a screw or a bolt to strengthen a connection between the first cover 10 and the second cover 20, and stability of an electrical connection between the first conductive layer 1 and the second cover 20 is better.

For example, when the second cover 20 includes the third conductive layer 21, the fourth conductive layer 23, and the second insulation layer 22, a part of the first conductive member 51 may be electrically connected to the third conductive layer 21.

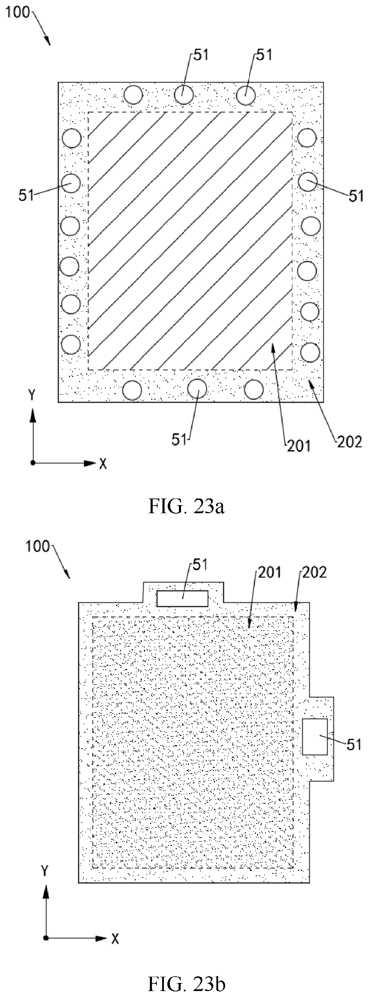

FIG. 23a is a diagram of a structure of the vapor chamber 100 shown in FIG. 14 to FIG. 22 at another angle. For ease of understanding, in FIG. 23a, the effective region 201, the edge sealing region 202, and the first conductive member 51 are schematically distinguished by using dashed lines and filling patterns.

As shown in FIG. 23a, in the thickness direction of the vapor chamber 100, a projection of the first conductive member 51 on the second cover 20 coincides with the edge sealing region 202. In this way, the area of the vapor chamber 100 on the X-Y plane is not increased additionally.

There may be one or more first conductive members 51 included in the vapor chamber 100. When there are a plurality of first conductive members 51, the plurality of first conductive members 51 are spaced. It may be understood that a width of the edge sealing region 202 of the second cover 20 is limited. When an electrical connection area of one disposed first conductive member 51 cannot meet a stability requirement for the electrical connection between the first conductive layer 1 and the second cover 20, the plurality of first conductive members 51 may be disposed, to increase an electrical connection area between the first conductive layer 1 and the second cover 20, thereby enhancing the stability of the electrical connection between the first conductive layer 1 and the second cover 20.

For example, the plurality of first conductive members 51 may be spaced around the effective region 201 of the second cover 20.

For example, FIG. 23a shows 18 first conductive members 51. The 18 first conductive members 51 may be spaced around the effective region 201 of the second cover 20. The three first conductive members 51 are located on an upper side of the effective region 201, the three first conductive members 51 are located on a lower side of the effective region 201, the six first conductive members 51 are located on a left side of the effective region 201, and the six first conductive members 51 are located on a right side of the effective region 201.

FIG. 23b is a diagram of a structure of the structure shown in FIG. 23a according to still another implementation. For ease of understanding, in FIG. 23b, the effective region 201, the edge sealing region 202, and the first conductive member 51 are schematically distinguished by using dashed lines and filling patterns.

As shown in FIG. 23b, the vapor chamber 100 may include two first conductive members 51, one first conductive member 51 may be located on the right side of the effective region 201, and one first conductive member 51 may be located on the upper side of the effective region 201.

For example, a width of the edge sealing region 202 in which the first conductive member 51 is disposed may be greater than a width of the edge sealing region 202 in which the first conductive member 51 is not disposed. In this way, when an area of the edge sealing region 202 meets a requirement of disposing the first conductive member 51, the area of the edge sealing region 202 is sufficient for fastening the second conductive layer 3, to ensure sealing stability of the accommodating cavity 101.

It may be understood that, in the thickness direction of the vapor chamber 100, the projection of the first conductive member 51 on the second cover 20 is not limited to a circle shown in FIG. 23a and a rectangle shown in FIG. 23b, and may alternatively be a triangle, an ellipse, a polygon, or another irregular shape.

It may be understood that when the vapor chamber 100 is provided with the plurality of first conductive members 51, shapes of the plurality of first conductive members 51 may also be different.

For example, when there is one first conductive member 51, the projection of the first conductive member 51 on the second cover 20 may be at any location in the edge sealing region 202.

In the foregoing embodiments shown in FIG. 14 to FIG. 17 and FIG. 22, the first through hole 4 communicates with the second through hole 24. With reference to the accompanying drawings, the following further describes an embodiment in which the first through hole 4 does not communicate with the second through hole 24.

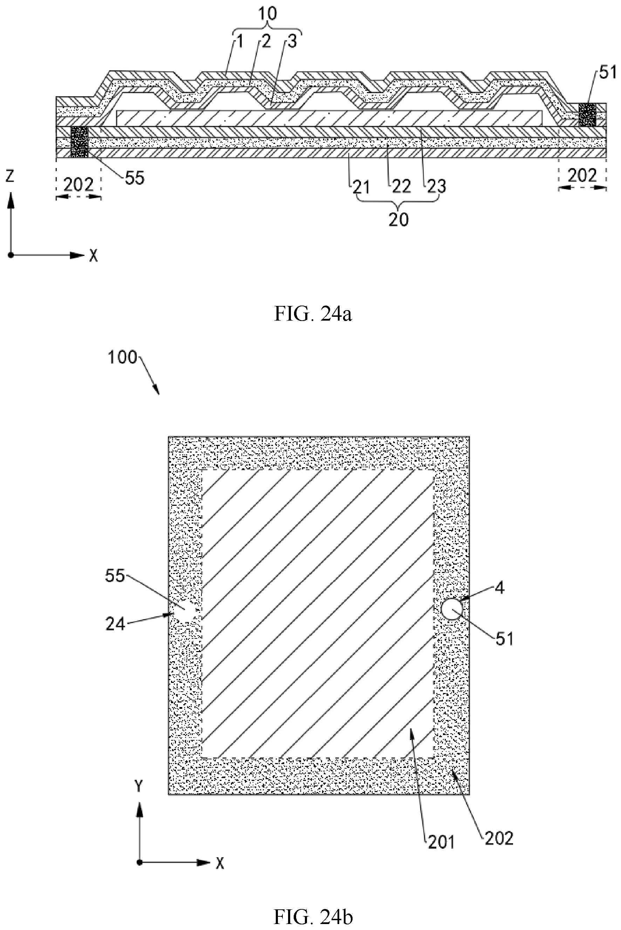

FIG. 24a is a diagram of a structure of the structure shown in FIG. 4 according to yet another implementation. FIG. 24b is a diagram of a structure of the structure shown in FIG. 24a at another angle according to an implementation.

As shown in FIG. 24a and FIG. 24b, the first cover 10 is provided with the first through hole 4. The first through hole 4 may penetrate the first conductive layer 1, the first insulation layer 2, and the second conductive layer 3. The edge sealing region 202 of the second cover 20 may be provided with the second through hole 24. The second through hole 24 penetrates the fourth conductive layer 23, the second insulation layer 22, and the third conductive layer 21. A projection of the first through hole 4 on the reference plane in the first direction and a projection of the second through hole 24 on the reference plane in the first direction are staggered. The second conductive layer 3 may be exposed from the second through hole 24. The reference plane is the plane on which the first conductive layer 1 is located. The first direction is the direction from the second cover 20 to the first cover 10.

In some implementations, the vapor chamber 100 may include the first conductive member 51 and a fifth conductive member 55. For example, the first conductive member 51 is located in the first through hole 4. One end of the first conductive member 51 is fastened to the first conductive layer 1, and the other end of the first conductive member 51 is fastened to the second conductive layer 3. In this way, the first conductive layer 1 may be electrically connected to the second conductive layer 3 through the first conductive member 51.

For example, the fifth conductive member 55 may be located in the second through hole 24. One end of the fifth conductive member 55 may be fastened to the second conductive layer 3, and the other end of the fifth conductive member 55 may be fastened to the third conductive layer 21. The second conductive layer 3 may be electrically connected to the third conductive layer 21 through the fifth conductive member 55.

It may be understood that the projection of the first through hole 4 on the reference plane in the first direction and the projection of the second through hole 24 on the reference plane in the first direction are staggered. When the first cover 10 and the second cover 20 are assembled, an assembly precision requirement is relatively low.

In other implementations, the first through hole 4 may not penetrate the second conductive layer 3; and one end of the first conductive member 51 may be fastened to the first conductive layer 1, and the other end of the first conductive member 51 may be fastened to the second conductive layer 3. The first conductive layer 1 may alternatively be electrically connected to the second conductive layer 3 through the first conductive member 51.

In other implementations, the second through hole 24 may not penetrate the fourth conductive layer 23. The second conductive layer 3 is electrically connected to the fourth conductive layer 23. One end of the fifth conductive member 55 may be fastened to the fourth conductive layer 23. In other words, one end of the fifth conductive member 55 is fastened to and electrically connected to the second conductive layer 3 through the fourth conductive layer 23.

For example, the first conductive layer 1 may be electrically connected to the third conductive layer 21 through the first conductive member 51, the second conductive layer 3, and the fifth conductive member 55.

In some implementations, the first conductive member 51 and the fifth conductive member 55 may be spaced.

In other implementations, the second through hole 24 may not penetrate the fourth conductive layer 23, and the fourth conductive layer 23 may be exposed from the second through hole 24. The first conductive layer 1 may be electrically connected to the third conductive layer 21 through the first conductive member 51, the second conductive layer 3, the fourth conductive layer 23, and the fifth conductive member 55.

In other implementations, when the second cover 20 is not provided with the fourth conductive layer 23, the first conductive layer 1 may also be electrically connected to the third conductive layer 21 through the first conductive member 51, the second conductive layer 3, and the fifth conductive member 55. For example, the second through hole 24 may not penetrate the third conductive layer 21, but penetrate only the second insulation layer 22. The fifth conductive member 55 may also implement electrical conduction between the second conductive layer 3 and the third conductive layer 21.

It may be understood that, when locations of the first through hole 4 and the second through hole 24 are selectively set, a conductive layer of the first cover 10 and/or the second cover 20 may be used for electrical conduction between the first conductive layer 1 and the third conductive layer 21, and layers that the first through hole 4 and the second through hole 24 respectively penetrate may be selected according to an actual situation.

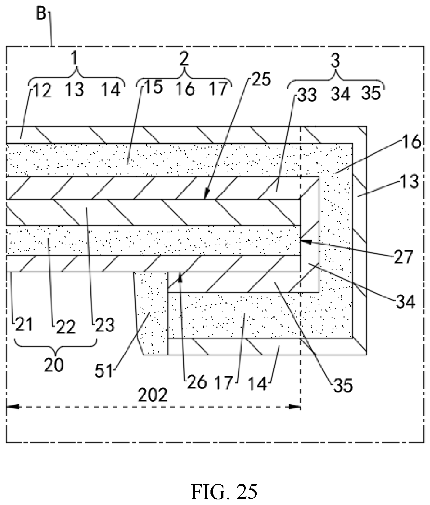

FIG. 25 is a diagram of a structure of the structure shown in FIG. 4 at a location B according to yet another implementation.

As shown in FIG. 4 and FIG. 25, the first conductive layer 1 may include a first part 12, a second part 13, and a third part 14 (the first part 12, the second part 13, and the third part 14 are schematically distinguished by using dashed lines in FIG. 25). The first insulation layer 2 may include a first part 15, a second part 16, and a third part 17 (the first part 15, the second part 16, and the third part 17 are schematically distinguished by using dashed lines in FIG. 25). The first part 15 of the first insulation layer 2 and the top surface 25 of the second cover 20 are disposed opposite to each other. The first part 12 of the first conductive layer 1 is located on a side that is of the first part 15 of the first insulation layer 2 and that is away from the top surface 25. The second part 16 of the first insulation layer 2 and the side surface 27 of the second cover 20 are disposed opposite to each other. The second part 13 of the first conductive layer 1 is located on a side that is of the second part 16 of the first insulation layer 2 and that is away from the side surface 27 of the second cover 20. The third part 17 of the first insulation layer 2 and the bottom surface 26 of the second cover 20 are disposed opposite to each other. The third part 14 of the first conductive layer 1 is located on a side that is of the third part 17 of the first insulation layer 2 and that is away from the bottom surface 26 of the second cover 20.

The first conductive member 51 may be located on a side that is of the second cover 20 and that is away from the accommodating cavity 101. For example, a part of the first conductive member 51 is fastened to the third part 14 of the first conductive layer 1, and a part of the first conductive member 51 is fastened to the bottom surface 26 of the second cover 20. The first conductive layer 1 is electrically connected to the bottom surface 26 of the second cover 20 through the first conductive member 51.

It may be understood that, when the vapor chamber 100 is installed on the electronic device 1000, the surface on the side that is of the second cover 20 and that is away from the second conductive layer 3 may be fastened to the middle frame 310. In this case, the first conductive member 51 may be located between the middle frame 310 and the second cover 20. In a process of using the electronic device 1000, the first conductive member 51 is not prone to fall-off when the electronic device 1000 is in scenarios such as falling, collision, and extrusion. Electrical connection reliability is higher.

In some implementations, the second conductive layer 3 may also include a first part 33, a second part 34, and a third part 35 (the first part 33, the second part 34, and the third part 35 are schematically distinguished by using dashed lines in FIG. 25). The first part 33 of the second conductive layer 3 may be connected between the top surface 25 of the second cover 20 and the first part 15 of the first insulation layer 2. The second part 344 of the second conductive layer 3 may be connected between the side surface 27 of the second cover 20 and the second part 16 of the first insulation layer 2. The third part 35 of the second conductive layer 3 may be connected between the bottom surface 26 of the second cover 20 and the third part 17 of the first insulation layer 2.

The foregoing describes several structures of the vapor chamber 100 with reference to the accompanying drawings. The following describes several manners of installing the vapor chamber 100 in the electronic device 1000 and several grounding manners of the vapor chamber 100 with reference to the accompanying drawings.

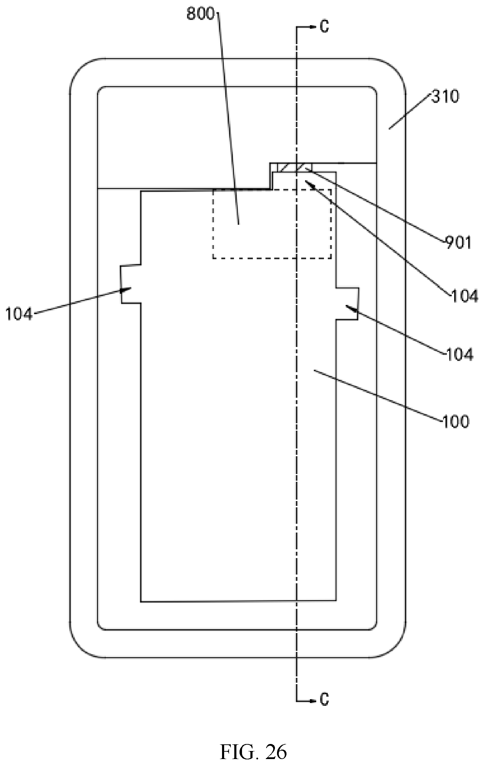

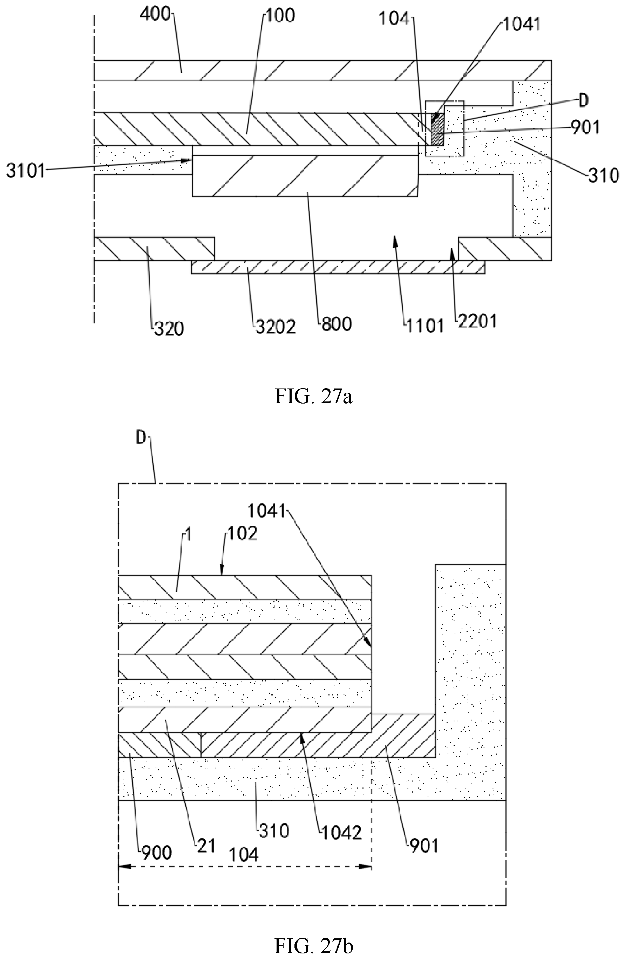

FIG. 26 is a diagram of assembling the middle frame 310 and the vapor chamber 100 shown in FIG. 2 according to an implementation. FIG. 27a is a partial cross-sectional view of a structure shown in FIG. 26 along a section line C-C according to an implementation. FIG. 27b is an enlarged diagram of the structure shown in FIG. 27a at a location D according to an implementation.

As shown in FIG. 26 to FIG. 27b, to implement more compact arrangement of the internal component of the electronic device 1000, reduce a thickness of the electronic device 1000, and improve heat transfer efficiency, an avoidance hole 3101 may be provided on the middle frame 310, and a part of the internal component 800 of the electronic device 1000 may be disposed in the avoidance hole.

For example, the internal component 800 may be a rear-facing camera module. The camera module may be located in the accommodation space 1001 of the electronic device 1000. The camera module may be fastened to the middle frame 310. A light collection surface of the camera module may face the rear cover 320. The rear cover 320 may be provided with a light transmission hole 2201. The light transmission hole 2201 communicates an inner side (that is, the accommodation space 1001) of the electronic device 1000 to an outer side of the electronic device 1000. Light outside the electronic device 1000 may enter the accommodation space 1001 of the electronic device 1000 through the light transmission hole 2201. The camera module may collect ambient light that enters the inner side of the electronic device 1000.

In some implementations, the rear cover 320 may include a light transmission lens 3202, and the light transmission lens 3202 may be installed in the light transmission hole 2201, to allow light to pass through and resist dust and water.

For example, the internal component 800 may also be a chip.

For example, there may be one or more avoidance holes 3101.

In some implementations, the vapor chamber 100 may include an extension region 104, and a side surface 1041 of the extension region 104 may be spaced from the middle frame 310. It may be understood that the vapor chamber 100 may be in an irregular shape on the X-Y plane, to match a shape of the middle frame 310 of the electronic device 1000. The shape of the middle frame 310 is related to an installation location of the internal component of the electronic device 1000. For example, the avoidance hole 3101 may be provided on the middle frame 310, and may be configured to install the camera module 800. When the vapor chamber 100 is installed on the middle frame 310, the extension region 104 may be disposed at a location near the avoidance hole 3101, and is configured to connect to the middle frame 310.

For example, the side surface 1041 of the extension region 104 may be a part of the side surface of the vapor chamber 100. The extension region 104 may include a part of the first conductive layer 1 or a part of the third conductive layer 21.

For example, the vapor chamber 100 may be bonded to the middle frame 310 by using a back adhesive 900. The back adhesive 900 may be an insulating material, or may be a conductive material.

In some implementations, in a thickness direction of the electronic device 1000, a projection of the extension region 104 on a plane on which the middle frame 310 is located at least partially overlaps the middle frame 310.

In some implementations, when the back adhesive 900 is an insulating material, the electronic device 1000 may further include a first electrical connection member 901. A part of the first electrical connection member 901 may be fastened to the vapor chamber 100 and electrically connected to the vapor chamber 100, and a part of the first electrical connection member 901 may be fastened to the middle frame 310 and electrically connected to the middle frame 310.

In some implementations, the first electrical connection member 901 may be at least partially fastened between the middle frame 310 and a bottom surface 1042 of the extension region 104. For example, the first electrical connection member 901 may be electrically connected to the first conductive layer 1 and/or the third conductive layer 21. Both the top surface 102 and the bottom surface 103 of the vapor chamber 100 may be electrically connected to the middle frame 310 through the first electrical connection member 901. The first electrical connection member 901 may be at least partially fastened between the middle frame 310 and the bottom surface 1042 of the extension region 104, and the first electrical connection member 901 is not prone to fall-off from the middle frame or the vapor chamber.

In some implementations, the first electrical connection member 901 may be partially connected to the first conductive layer 1. A part of the first electrical connection member 901 is connected to the third conductive layer 21, and another part of the first electrical connection member 901 is connected to the middle frame 310. The first electrical connection member 901 may be made of a conductive material. In this way, both the third conductive layer 21 and the first conductive layer 1 of the vapor chamber 100 may be electrically connected to the middle frame 310 through the first electrical connection member 901.

It may be understood that, when the back adhesive 900 is an insulating material, the first electrical connection member 901 may be disposed, so that both the second cover 20 and the first conductive layer 1 of the vapor chamber 100 can be electrically connected to the middle frame 310 through the first electrical connection member 901. For example, the first electrical connection member 901 is electrically connected to the first conductive layer 1 of the vapor chamber 100. The bottom surface 103 of the vapor chamber 100 may be electrically connected to the first conductive layer 1 through the first conductive member 51, and further grounded through the first electrical connection member 901. The first conductive layer 1 may be directly grounded through the first electrical connection member 901. Therefore, when the top surface 102 or the bottom surface 103 of the vapor chamber 100 is in unstable electrical contact with an electriferous component in the electronic device 1000, a current may be grounded through the first electrical connection member 901.

For example, the first electrical connection member 901 may be conductive foam, a conductive adhesive, a conductive slurry, or a metal sheet.

In some implementations, the first electrical connection member 901 may alternatively be at least partially fastened between the middle frame 310 and the side surface 1041 of the extension region 104. It may be understood that, when the first electrical connection member 901 is a conductive slurry or a conductive adhesive, a gap between the middle frame 310 and the side surface 1041 of the extension region 104 may be used to accommodate overflow of the first electrical connection member 901.

In some implementations, a minimum value of a resistance value between any point on the top surface 102 of the vapor chamber 100 and any point on the middle frame 310 may be less than 10¹⁵ ohms (Ω). For example, the resistance value between any point on the top surface 102 of the vapor chamber 100 and any point on the middle frame 310 may be less than 1000 Ω. The resistance value between any point on the top surface 102 and any point on the middle frame 310 may be 0.05 Ω, 0.5 Ω, 1 Ω, 3 Ω, 5 Ω, 20 Ω, 200 Ω, 500 Ω, 700 Ω, or 999 Ω. In this case, the resistance value between the top surface 102 and the middle frame 310 in an electrical connection state is relatively small. Grounding effect of the top surface 102 and the bottom surface 103 of the vapor chamber 100 is relatively good.

In some implementations, the first electrical connection member 901 may be further connected to the top surface 102 of the vapor chamber 100.

In some implementations, when the back adhesive 900 is a conductive material, the vapor chamber 100 may be electrically connected to the middle frame 310 by using the back adhesive 900. There may be no need to reserve a space for disposing the first electrical connection member 901. Arrangement of the internal component of the electronic device 1000 is simpler. A space originally reserved for disposing the first electrical connection member 901 may be used to arrange other components required by the electronic device 1000, to facilitate multi-function of the electronic device 1000.

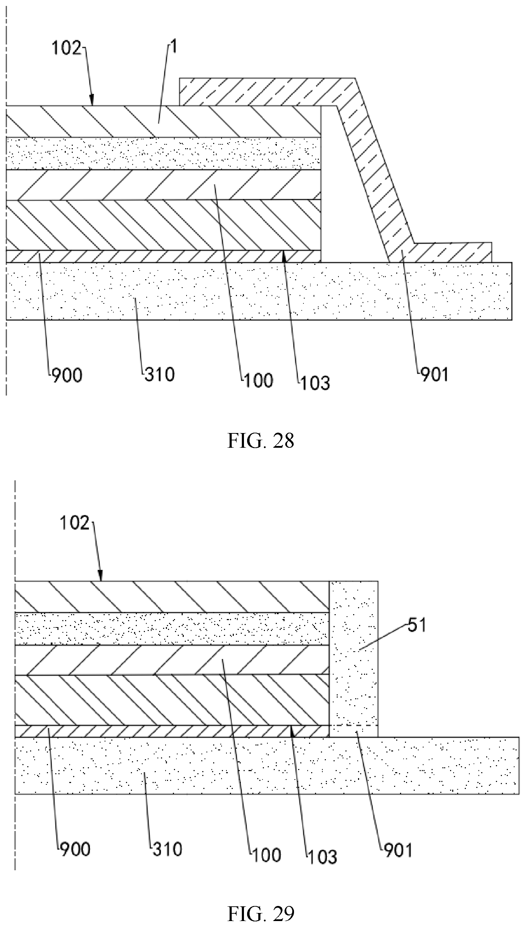

In some implementations, technical content that is the same as that in the foregoing implementations is not described herein again. FIG. 28 is a diagram of an electrical connection of the middle frame 310 and the vapor chamber 100 shown in FIG. 2 according to another implementation.

As shown in FIG. 28, when the vapor chamber 100 is installed on the middle frame 310, a part of the first electrical connection member 901 may be fastened to the top surface 102 of the vapor chamber 100, and a part of the first electrical connection member 901 may be fastened to the middle frame 310. In this way, the top surface 102 of the vapor chamber 100 may be electrically connected to the middle frame 310 through the first electrical connection member 901. For example, a surface on a side that is of the first conductive layer 1 of the vapor chamber 100 and that is away from the second cover 20 is the top surface 102 of the vapor chamber 100, and the first electrical connection member 901 may be connected to the first conductive layer 1 of the vapor chamber 100 and the middle frame 310.

It may be understood that technical difficulty of fastening the first electrical connection member 901 to the vapor chamber 100 and the middle frame 310 is lower, and difficulty in assembling the electronic device 1000 is lower in this embodiment compared with the electrical connection solution shown in FIG. 27b.

It may be understood that, with reference to FIG. 4 and FIG. 28, electrical conduction is implemented between the top surface 102 and the bottom surface 103 of the vapor chamber 100 by using the first conductive member 51. Therefore, when the bottom surface 103 of the vapor chamber 100 is in unstable electrical contact with the internal component of the electronic device 100, a current may be grounded sequentially through the bottom surface 103, the first conductive member 51, the top surface 102, the first electrical connection member 901, and the middle frame 310.

In some implementations, technical content that is the same as that in the foregoing implementations is not described herein again. FIG. 29 is a diagram of an electrical connection of the middle frame 310 and the vapor chamber 100 shown in FIG. 2 according to still another implementation.

As shown in FIG. 29, when the vapor chamber 100 is installed on the middle frame 310, the first electrical connection member 901 may be partially connected to the first conductive member 51, and partially connected to the middle frame 310. The first electrical connection member 901 may be electrically connected to the first conductive member 51. In this way, both the top surface 102 or the bottom surface 103 of the vapor chamber 100 may be grounded through a path of the first conductive member 51, the first electrical connection member 901, and the middle frame 310.

It may be understood that there may be a plurality of first electrical connection members 901, and the plurality of first electrical connection members 901 are spaced. Locations at which the plurality of first electrical connection members 901 are connected to the vapor chamber 100 may be different. In other words, the plurality of first electrical connection members 901 may use one or more of forms in FIG. 27a, FIG. 28, and FIG. 29.

In some implementations, there may be a plurality of extension regions 104, and the plurality of first electrical connection members 901 are respectively correspondingly connected to the plurality of extension regions 104.

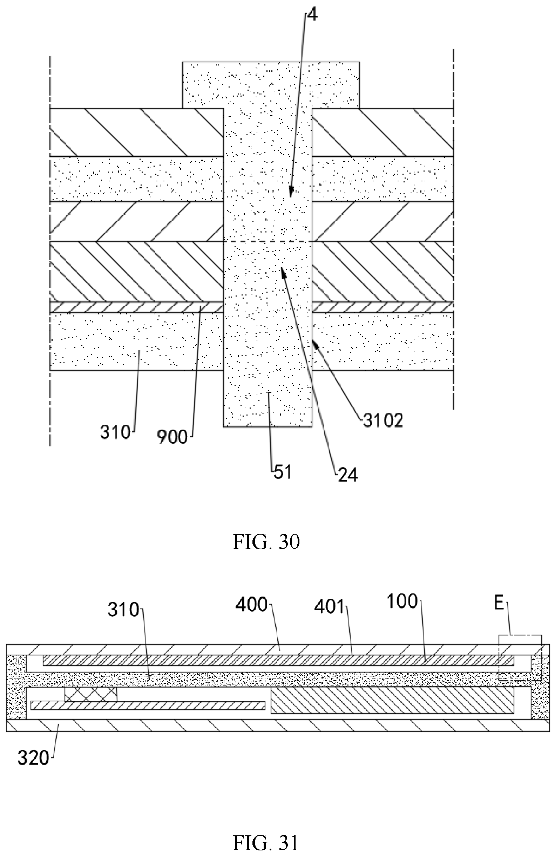

In some implementations, technical content that is the same as that in the foregoing implementations is not described herein again. FIG. 30 is a diagram of an electrical connection of the middle frame 310 and the vapor chamber 100 shown in FIG. 2 according to yet another implementation.

As shown in FIG. 3 and FIG. 30, the first conductive member 51 of the vapor chamber 100 may alternatively be directly electrically connected to the middle frame 310. For example, when the first conductive member 51 of the vapor chamber 100 is a screw, the middle frame 310 may be provided with a mounting hole 3102. The first conductive member 51 may be partially fastened in the first through hole 4, partially fastened in the second through hole 24, and partially fastened in the mounting hole 3102. The first conductive member 51 may be in contact with and electrically connected to the vapor chamber 100 and the middle frame 310. It may be understood that the middle frame 310 is generally made of a conductive metal material, and the first conductive member 51 is made of a conductive material. Therefore, the first conductive member 51 may be electrically connected to the middle frame 310.

It may be understood that the middle frame 310 is electrically connected through the first conductive member 51, and no electrical connection structure needs to be additionally disposed between the vapor chamber 100 and the middle frame 310. In addition, the first conductive member 51 of the vapor chamber 100 may be further configured to strengthen a connection between the vapor chamber 100 and the middle frame 310.

In some implementations, when the vapor chamber 100 uses the structure shown in FIG. 13, the free end of the first conductive member 51 may be configured to electrically connect to the middle frame 310.

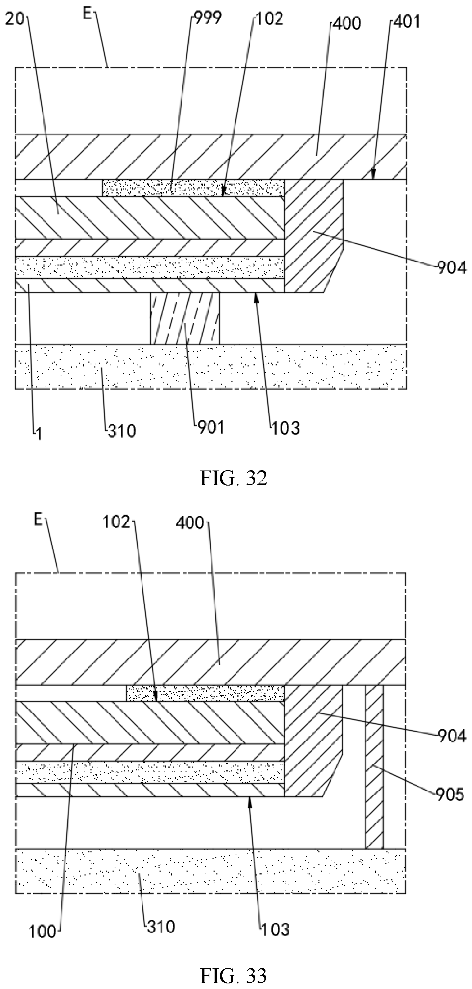

In some implementations, technical content that is the same as that in the foregoing implementations is not described herein again. FIG. 31 is a diagram of a partial structure of the electronic device 1000 shown in FIG. 1 along a line A-A according to another implementation. FIG. 32 is an enlarged diagram of the structure shown in FIG. 31 at a location E according to an implementation.

As shown in FIG. 31 and FIG. 32, the vapor chamber 100 may be installed on a rear surface 401 of the screen 400. The rear surface 401 of the screen 400 and the display surface of the screen 400 are disposed opposite to each other. For example, the vapor chamber 100 may be bonded to the rear surface 401 of the screen 400 by using a back adhesive 999. It may be understood that when the vapor chamber 100 is installed on the screen 400, the screen 400 is a support member.

In some implementations, the back adhesive 999 does not fully cover the top surface 102 of the vapor chamber 100, and a part of the top surface 102 of the vapor chamber 100 may face and be spaced from the rear surface 401 of the screen 400. In this way, when the vapor chamber 100 is installed on the rear surface 401 of the screen 400, a component disposed on the rear surface 401 of the screen 400 can be avoided, to avoid interference to working of the screen 400.

In some implementations, when the vapor chamber 100 is installed on the screen 400, the first conductive layer 1 may be fastened to the rear surface 401 of the screen 400, or the second cover 20 may be fastened to the rear surface 401 of the screen 400. In FIG. 31, description is provided by using an example in which the second cover 20 is fastened to the screen 400.

For example, the top surface 102 of the vapor chamber 100 faces the screen, and the bottom surface 103 of the vapor chamber 100 faces the middle frame 310. When the second cover 20 is fastened to the screen 400, a surface on a side that is of the second cover 20 and that faces the screen 400 is the top surface 102 of the vapor chamber 100, and a surface on a side that is of the first conductive layer 1 and that is opposite to the screen 400 is the bottom surface 103 of the vapor chamber 100.

In some implementations, a part of the first electrical connection member 901 may be connected to the bottom surface 103 of the vapor chamber 100, and a part of the first electrical connection member 901 may be connected to the middle frame 310. The bottom surface 103 of the vapor chamber 100 may be electrically connected to the middle frame 310 through the first electrical connection member 901. The middle frame 310 is grounded. In this way, the bottom surface 103 of the vapor chamber 100 may be grounded sequentially through the first electrical connection member 901 and the middle frame 310. Electrical conduction is implemented between the top surface 102 and the bottom surface 103 of the vapor chamber 100 by using the first conductive member 51. When the screen 400 is in unstable electrical contact with the top surface 102 of the vapor chamber 100, a current on the top surface 102 of the vapor chamber 100 may be grounded sequentially through the top surface 102 of the vapor chamber 100, the first conductive member 51, the bottom surface 103 of the vapor chamber 100, the first electrical connection member 901, and the middle frame 310.

It may be understood that the bottom surface 103 of the vapor chamber 100 may be electrically connected to the middle frame 310 through the first electrical connection member 901. When unstable electrical contact occurs between an internal electriferous component of the electronic device 1000 and the top surface 102 and/or the bottom surface 103 of the vapor chamber 100 when the electronic device 1000 is subject to external force or a user presses the screen 400, the top surface 102 and the bottom surface 103 of the vapor chamber 100 are electrically connected through the first conductive member 51. Therefore, a current on the bottom surface 103 of the vapor chamber 100 may be grounded through a path: the bottom surface 103-the first electrical connection member 901-the middle frame 310. A current on the top surface 102 of the vapor chamber 100 may be grounded through a path: the top surface 102-the first conductive member 51-the bottom surface 103-the first electrical connection member 901-the middle frame 310.

For example, the first electrical connection member 901 may be a conductive adhesive, a conductive sheet, conductive foam, or a conductive spring sheet.

In some implementations, the screen 400 and the vapor chamber 100 may share the first electrical connection member 901 for grounding. The electronic device 1000 may further include a second electrical connection member 904. One end of the second electrical connection member 904 is connected to the vapor chamber 100, and the other end of the second electrical connection member 904 is connected to the rear surface 401 of the screen 400. One end of the second electrical connection member 904 is electrically connected to the top surface 102 and/or the bottom surface 103 of the vapor chamber 100, and the other end of the second electrical connection member 904 is electrically connected to the screen 400. The screen 400 may be electrically connected to the middle frame 310 through the second electrical connection member 904, the vapor chamber 100, and the first electrical connection member 901.

It may be understood that a ground path of the screen 400 is related to an electrical connection location between the second electrical connection member 904 and the vapor chamber 100. For example, one end of the second electrical connection member 904 may be in contact with and electrically connected to the top surface 102 and the bottom surface 103 of the vapor chamber 100. The screen 400 may be grounded through a path: the second electrical connection member 904-the top surface 102-the first conductive member 51-the bottom surface 103-the first electrical connection member 901-the middle frame 310. In addition, the screen 400 may be further grounded through a path: the second electrical connection member 904-the bottom surface 103-the first electrical connection member 901-the middle frame 310.

In other implementations, when one end of the second electrical connection member 904 is merely in contact with and electrically connected to the top surface 102 of the vapor chamber 100, the screen 400 may be grounded through a path: the second electrical connection member 904-the top surface 102-the first conductive member 51-the bottom surface 103-the first electrical connection member 901-the middle frame 310.

For example, the second electrical connection member 904 may be a conductive adhesive or a conductive sheet.

In some implementations, technical content (the embodiment shown in FIG. 32) that is the same as that in the foregoing implementations is not described herein again. FIG. 33 is an enlarged diagram of the structure shown in FIG. 31 at a location E according to another implementation.

As shown in FIG. 31 and FIG. 33, the electronic device 1000 may not be provided with the first electrical connection member 901, and the electronic device 1000 may include the second electrical connection member 904 and a third electrical connection member 905. One end of the third electrical connection member 905 may be fastened to the screen 400 and electrically connected to the screen 400, and the other end of the third electrical connection member 905 may be fastened to the middle frame 310 and electrically connected to the middle frame 310. In this way, the screen 400 may be electrically connected to the middle frame 310 through the third electrical connection member 905, and then grounded through the middle frame 310.

It may be understood that ground paths of two locations of the top surface 102 and the bottom surface 103 of the vapor chamber 100 are related to an electrical connection location between the second electrical connection member 904 and the vapor chamber 100.

For example, when one end of the second electrical connection member 904 is in contact with and electrically connected to the top surface 102 and the bottom surface 103 of the vapor chamber 100, the top surface 102 of the vapor chamber 100 may be grounded through a path: the top surface 102-the first conductive member 51-the bottom surface 103-the second electrical connection member 904-the screen 400-the third electrical connection member 905-the middle frame 310. In addition, the top surface 102 of the vapor chamber 100 may be further grounded through a path: the top surface 102-the second electrical connection member 904-the screen 400-the third electrical connection member 905-the middle frame 310. The bottom surface 103 of the vapor chamber 100 may be further grounded through a path: the bottom surface 103-the second electrical connection member 904-the screen 400-the third electrical connection member 905-the middle frame 310.

For example, when one end of the second electrical connection member 904 is merely in contact with and electrically connected to the top surface 102 of the vapor chamber 100, the top surface 102 of the vapor chamber 100 may be grounded through a path: the top surface 102-the second electrical connection member 904-the screen 400-the third electrical connection member 905-the middle frame 310. The bottom surface 103 of the vapor chamber 100 may be further grounded through a path: the bottom surface 103-the first conductive member 51-the top surface 102-the second electrical connection member 904-the screen 400-the third electrical connection member 905-the middle frame 310.

For example, when one end of the second electrical connection member 904 is merely in contact with and electrically connected to the bottom surface 103 of the vapor chamber 100, the top surface 102 of the vapor chamber 100 may be grounded through a path: the top surface 102-the first conductive member 51-the bottom surface 103-the second electrical connection member 904-the screen 400-the third electrical connection member 905-the middle frame 310. The bottom surface 103 of the vapor chamber 100 may be further grounded through a path: the bottom surface 103-the second electrical connection member 904-the screen 400-the third electrical connection member 905-the middle frame 310.

It may be understood that the screen 400 and the vapor chamber 100 may share the third electrical connection member 905 for grounding.

For example, the third electrical connection member 905 may be a conductive adhesive, a conductive sheet, conductive foam, or a conductive spring sheet.

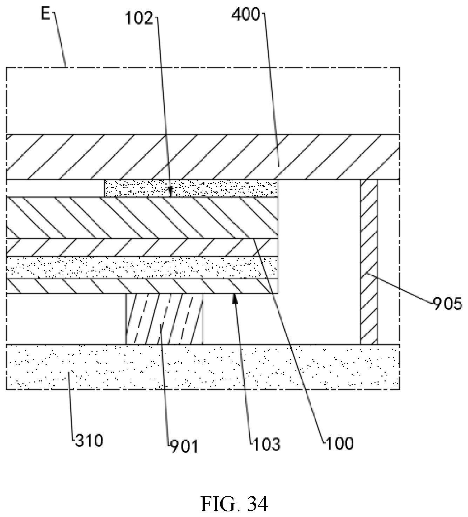

In some implementations, technical content (the embodiments shown in FIG. 32 and FIG. 33) that is the same as that in the foregoing implementations is not described herein again. FIG. 34 is an enlarged diagram of the structure shown in FIG. 31 at a location E according to still another implementation.

It may be understood that the foregoing conductive members may be disposed according to a requirement, and conductive members in different embodiments may also be used in combination according to a requirement.

As shown in FIG. 33, the vapor chamber 100 and the screen 400 are separately electrically connected to the middle frame 310, and the vapor chamber 100 and the screen 400 do not share a ground path. The electronic device 1000 may be provided with the first electrical connection member 901 and the third electrical connection member 905. Insulation is implemented between the vapor chamber 100 and the screen 400. The top surface 102 of the vapor chamber 100 may be grounded through a path: the top surface 102-the first conductive member 51-the bottom surface 103-the first electrical connection member 901-the middle frame 310. The bottom surface 103 of the vapor chamber 100 may be grounded through a path: the bottom surface 103-the first electrical connection member 901-the middle frame 310. The screen 400 may be grounded through a path: the screen 400-the third electrical connection member 905-the middle frame 310.

In other implementations, the electronic device 1000 may be provided with the third electrical connection member 905, the second electrical connection member 904, and the third electrical connection member 905.

In this way, the top surface 102 and the bottom surface 103 of the vapor chamber 100 may have a plurality of ground paths. When one of the paths fails, other paths can still work normally, so that the vapor chamber 100 can be stably grounded.

In some implementations, technical content that is the same as that in the foregoing implementations is not described herein again.

This application further provides an electronic device. The electronic device may include a vapor chamber, a heat emitting component, a housing 300, and a screen 400. The screen 400 is installed in the housing 300. The housing 300 and the screen 400 jointly enclose an accommodation space in the electronic device. Both the vapor chamber and the heat emitting component are installed in the accommodation space of the electronic device 1000. For an installation manner of the vapor chamber, the heat emitting component, the housing, and the screen, refer to the foregoing installation manner of the vapor chamber 100, the heat emitting component 200, the housing 300, and the screen 400. Details are not described herein again.

The vapor chamber may include a first cover 10, a second cover 20, a capillary structure 30, and a cooling medium 40. For a manner of disposing the first cover 10, the second cover 20, the capillary structure 30, and the cooling medium 40, refer to the foregoing manner of disposing the first cover 10, the second cover 20, the capillary structure 30, and the cooling medium 40.

The electronic device may further include an electrical connection structure. A part of the electrical connection structure is fastened to the vapor chamber, and is electrically connected to a top surface and a bottom surface of the vapor chamber. A part of the electrical connection structure is fastened to the housing/screen, and is electrically connected to a ground end of the electronic device. The top surface and the bottom surface of the vapor chamber may be grounded through the electrical connection structure.

For example, the first cover 10 includes a first conductive layer 1, a first insulation layer 2, and a second conductive layer 3. The first insulation layer 2 is connected between the first conductive layer 1 and the second conductive layer 3. The second conductive layer 3 is located on a side that is of the first insulation layer 2 and that is close to the second cover 20. A part of the electrical connection structure may be fastened to the first conductive layer 1, and is electrically connected to the first conductive layer 1. A surface on a side that is of the first conductive layer 1 and that is away from the first insulation layer 2 is a top surface of the vapor chamber.

In some possible implementations, the second cover 20 is made of a conductive material. For example, a part of the electrical connection structure may be fastened to any location of the second cover 20, and may be electrically connected to the second cover 20. For example, a part of the electrical connection structure may be further fastened to the second conductive layer 3, and the electrical connection structure may be electrically connected to the second cover 20 through the second conductive layer 3.

In some possible implementations, the second cover 20 includes a third conductive layer 21 and a second insulation layer 22 that are stacked, and the second insulation layer 22 is located on a side that is of the third conductive layer 21 and that is close to the second conductive layer 3. A surface on a side that is of the third conductive layer 21 and that is away from the second insulation layer 22 is a bottom surface of the vapor chamber. A part of the electrical connection structure may be fastened to the third conductive layer 21, and is electrically connected to the third conductive layer 21.

For example, the housing 300 may include a middle frame 310 and a rear cover 320. The ground end of the electronic device may be the middle frame. A part of the electrical connection structure may be fastened to the middle frame 310, and may be electrically connected to the middle frame 310. In other implementations, the electrical connection structure may also be fastened to the screen 400, and may be electrically connected to the ground end of the electronic device through another electrical connection member, to implement grounding of the top surface and the bottom surface of the vapor chamber.

For example, the electrical connection structure may be a conductive slurry, a metal sheet, conductive foam, or a conductive adhesive.

It may be understood that embodiments of this application and features in embodiments may be combined with each other when there is no conflict, and any combination of features in different embodiments also falls within the protection scope of this application. In other words, the plurality of embodiments described above may be further randomly combined based on an actual requirement.

It may be understood that all of the foregoing accompanying drawings are example drawings of this application, and do not represent actual sizes of products. In addition, a size proportional relationship between components in the accompanying drawings is not intended to limit an actual product in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A vapor chamber (100), comprising a first cover (10), a second cover (20), a capillary structure (30), a cooling medium (40), and a first conductive member (51), wherein the second cover (20) comprises an effective region (201) and an edge sealing region (202), and the edge sealing region (202) is connected to a peripheral edge of the effective region (201); a part of the first cover (10) is fastened to the edge sealing region (202) of the second cover (20), and a part of the first cover (10) is spaced from the effective region (201) of the second cover (20), to enclose an accommodating cavity (101); and the capillary structure (30) and the cooling medium (40) are located in the accommodating cavity (101);
the first cover (10) comprises a first conductive layer (1), a first insulation layer (2), and a second conductive layer (3), the first insulation layer (2) is connected between the first conductive layer (1) and the second conductive layer (3), and the second conductive layer (3) is located on a side that is of the first insulation layer (2) and that is close to the second cover (20); and
a part of the first conductive member (51) is connected to the first conductive layer (1), and a part of the first conductive member (51) is connected to the second cover (20); and the first conductive layer (1) is electrically connected, through the first conductive member (51), to a surface that is of the second cover (20) and that is away from the accommodating cavity (101).

2. The vapor chamber (100) according to claim 1, wherein the second cover (20) comprises a third conductive layer (21) and a second insulation layer (22) that are stacked, and the second insulation layer (22) is located on a side that is of the third conductive layer (21) and that is close to the second conductive layer (3); and
a part of the first conductive member (51) is fastened to the first conductive layer (1), and a part of the first conductive member (51) is fastened to the third conductive layer (21); and the first conductive layer (1) is electrically connected to the third conductive layer (21) through the first conductive member (51).

3. The vapor chamber (100) according to claim 2, wherein the first conductive member (51) and the first conductive layer (1) are an integrally formed mechanical member.

4. The vapor chamber (100) according to claim 2 or 3, wherein a part of the first conductive member (51) is fastened to a side surface (11) of the first conductive layer (1), and a part of the first conductive member (51) is fastened to a side surface (212) of the third conductive layer (21); or
a part of the first conductive member (51) is fastened to a side surface (11) of the first conductive layer (1), and a part of the first conductive member (51) is fastened to a surface that is of the third conductive layer (21) and that is away from the accommodating cavity (101).

5. The vapor chamber (100) according to claim 2 or 3, wherein the vapor chamber (100) further comprises a second conductive member (53); a part of the second conductive member (53) is fastened to the third conductive layer (21), and a part of the second conductive member (53) is fastened to the first conductive member (51); and the first conductive layer (1) is electrically connected to the third conductive layer (21) through the first conductive member (51) and the second conductive member (53).

6. The vapor chamber (100) according to claim 5, wherein the second conductive member (53) and the third conductive layer (21) are an integrally formed mechanical member.

7. The vapor chamber (100) according to claim 5 or 6, wherein the first conductive member and the second conductive member (53) are arranged in a first direction, and the first direction is a direction from the second cover (20) to the first cover (10); or
a part of the second conductive member (53) is fastened to a side that is of the first conductive member (51) and that is away from the accommodating cavity (101); or
a part of the first conductive member (51) is fastened to a side that is of the second conductive member (53) and that is away from the accommodating cavity (101).

8. The vapor chamber (100) according to claim 5 or 6, wherein the second cover (20) further comprises a fourth conductive layer (23), the fourth conductive layer (23) is stacked on the second insulation layer (22), and the fourth conductive layer (23) is located on a side that is of the second insulation layer (22) and that is close to the accommodating cavity (101).

9. The vapor chamber (100) according to claim 8, wherein the vapor chamber further comprises a third conductive member (52), the third conductive member (52) is fastened between the first conductive member (51) and the second conductive member (53), and the first conductive layer (1) is electrically connected to the third conductive layer (21) through the first conductive member (51), the third conductive member (52), and the second conductive member (53); or
the vapor chamber (100) further comprises a fourth conductive member (54), the fourth conductive member (54) is fastened between the first conductive member (51) and the second conductive member (53), and the first conductive layer (1) is electrically connected to the third conductive layer (21) through the first conductive member (51), the fourth conductive member (54), and the second conductive member (53); or
the vapor chamber (100) further comprises a third conductive member (52) and a fourth conductive member (54), the first conductive member (51), the third conductive member (52), the fourth conductive member (54), and the second conductive member (53) are arranged in a first direction, the third conductive member (52) is fastened between the fourth conductive member (54) and the first conductive layer (1), the fourth conductive member (54) is fastened between the third conductive member (52) and the second conductive member (53), the first conductive layer (1) is electrically connected to the third conductive layer (21) through the first conductive member (51), the third conductive member (52), the fourth conductive member (54), and the second conductive member (53), and the first direction is a direction from the second cover (20) to the first cover (10).

10. The vapor chamber (100) according to claim 9, wherein the third conductive member (52) and the second conductive layer (3) are an integrally formed mechanical member, and/or the fourth conductive member (54) and the fourth conductive layer (23) are an integrally formed mechanical member.

11. The vapor chamber (100) according to claim 8, wherein a part of the first conductive member (51) is fastened to the first conductive layer (1), and a part of the first conductive member (51) is fastened to the second conductive layer (3); and a part of the second conductive member (53) is fastened to the third conductive layer (21), and a part of the second conductive member (53) is fastened to the fourth conductive layer (23); and
the second conductive layer (3) is electrically connected to the fourth conductive layer (23), and the first conductive layer (1) is electrically connected to the third conductive layer (21) through the first conductive member (51), the second conductive layer (3), the fourth conductive layer (23), and the second conductive member (53).

12. The vapor chamber (100) according to claim 11, wherein a projection of the first conductive member (51) on a reference plane in a first direction and a projection of the second conductive member (53) on the reference plane in the first direction are at least partially staggered, the reference plane is a plane on which the first conductive layer (1) is located, and the first direction is a direction from the second cover (20) to the first cover (10); or
the first conductive member (51) and the second conductive member (53) are spaced.

13. The vapor chamber (100) according to claim 2, wherein the first conductive member (51) is an independent mechanical member.

14. The vapor chamber (100) according to claim 13, wherein a part of the first conductive member (51) is fastened to a side surface (11) of the first conductive layer (1), and a part of the first conductive member (51) is fastened to a side surface (212) of the third conductive layer (21).

15. The vapor chamber (100) according to claim 13, wherein a part of the first conductive member (51) is fastened to a surface that is of the first conductive layer (1) and that is away from the accommodating cavity (101), and a part of the first conductive member (51) is fastened to a side surface (212) of the third conductive layer (21); or
a part of the first conductive member (51) is fastened to a side surface (11) of the first conductive layer (1), and a part of the first conductive member (51) is fastened to a surface that is of the third conductive layer (21) and that is away from the accommodating cavity (101); or
a part of the first conductive member (51) is fastened to a surface that is of the first conductive layer (1) and that is away from the accommodating cavity (101), and a part of the first conductive member (51) is fastened to a surface that is of the third conductive layer (21) and that is away from the accommodating cavity (101).

16. The vapor chamber (100) according to claim 14, wherein the first conductive member (51) comprises a first submember (591) and a second submember (592); a part of the first submember (591) is fastened to a surface that is of the first conductive layer (1) and that is away from the first insulation layer (2), and a part of the first submember (591) is fastened to the second submember (592); and a part of the second submember (592) is fastened to a surface that is of the third conductive layer (21) and that is away from the second insulation layer (22); and
the first submember (591) and the second submember (592) are two independent mechanical members, or the first submember (591) and the second submember (592) are an integrally formed mechanical member.

17. The vapor chamber (100) according to claim 2, wherein the first cover (10) is provided with a first through hole (4), the first through hole (4) penetrates the first conductive layer (1), the first insulation layer (2), and the second conductive layer (3), a second through hole (24) is provided in the edge sealing region (203) of the second cover (20), the second through hole (24) penetrates the second insulation layer (22) and a third conductive layer (21), the first through hole (4) and the accommodating cavity (101) are spaced, and the first through hole (4) communicates with the second through hole (24); and
a part of the first conductive member (51) is located in the first through hole (4), and a part of the first conductive member (51) is located in the second through hole (24); one end of the first conductive member (51) is fastened to the first conductive layer (1), and the other end of the first conductive member (51) is fastened to the third conductive layer (21); and the first conductive layer (1) is electrically connected to the third conductive layer (21) through the first conductive member (51).

18. The vapor chamber (100) according to claim 2, wherein the first cover (10) is provided with a first through hole (4), the first through hole (4) penetrates the first conductive layer (1) and the first insulation layer (2), the edge sealing region (203) of the second cover (20) is provided with a second through hole (24), and the second through hole (24) penetrates the second insulation layer (22) and the third conductive layer (21);
a projection of the first through hole (4) on a reference plane in a first direction and a projection of the second through hole (24) on the reference plane in the first direction are staggered, the second conductive layer (3) is exposed from the second through hole (24), the reference plane is a plane on which the first conductive layer (1) is located, and the first direction is a direction from the second cover (20) to the first cover (10);
the vapor chamber (100) further comprises a fifth conductive member (55), and the first conductive member (51) is located in the first through hole (4); one end of the first conductive member (51) is fastened to the first conductive layer (1), and the other end of the first conductive member (51) is fastened to the second conductive layer (3); the fifth conductive member (55) is located in the second through hole (24); and one end of the fifth conductive member (55) is fastened to the second conductive layer (3), and the other end of the fifth conductive member (55) is fastened to the third conductive layer (21); and
the first conductive layer (1) is electrically connected to the third conductive layer (21) through the first conductive member (51), the second conductive layer (3), and the fifth conductive member (55).

19. The vapor chamber (100) according to claim 1, wherein the second cover (20) is made of a conductive material.

20. The vapor chamber (100) according to claim 19, wherein the first cover (10) is provided with a first through hole (4), the first through hole (4) penetrates the first conductive layer (1), the first insulation layer (2), and the second conductive layer (3), the first through hole (4) and the accommodating cavity (101) are spaced, and the second cover (20) is exposed from the first through hole (4); and
the first conductive member (51) is located in the first through hole (4); and one end of the first conductive member (51) is fastened to the first conductive layer (1), and the other end of the first conductive member (51) is fastened to the second cover (20).

21. The vapor chamber (100) according to claim 19, wherein the first cover (10) is provided with a first through hole (4), the first through hole (4) penetrates the first conductive layer (1) and the first insulation layer (2), the first through hole (4) and the accommodating cavity (101) are spaced, and the second conductive layer (3) is exposed from the first through hole (4); and
the first conductive member (51) is located in the first through hole (4); one end of the first conductive member (51) is fastened to the first conductive layer (1) and electrically connected to the first conductive layer (1), and the other end of the first conductive member (51) is fastened to the second conductive layer (3) and electrically connected to the second conductive layer (3); and the second conductive layer (3) is electrically connected to the second cover (20).

22. The vapor chamber (100) according to any one of claims 17, 18, 20, and 21, wherein the first conductive member (51) is of a solid structure.

23. The vapor chamber (100) according to any one of claims 17, 18, 20, and 21, wherein the first conductive member (51) is of a hollow-out structure.

24. The vapor chamber (100) according to claim 2 or 19, wherein the second cover (20) comprises a top surface (25), a bottom surface (26), and a side surface (27), the bottom surface and the top surface are disposed opposite to each other, the side surface is connected between the top surface and the bottom surface, and the top surface faces the accommodating cavity (101);
the first conductive layer (1) comprises a first part (12), a second part (13), and a third part (14), the first insulation layer (2) comprises a first part (15), a second part (16), and a third part (17), the first part (15) of the first insulation layer (2) and the top surface (25) are disposed opposite to each other, the first part (12) of the first conductive layer (1) is located on a side that is of the first part (15) of the first insulation layer (2) and that is away from the top surface (25), the second part (16) of the first insulation layer (2) and the side surface (27) are disposed opposite to each other, the second part (13) of the first conductive layer (1) is disposed on a side that is of the second part (16) of the first insulation layer (2) and that is away from the side surface (27), the third part (17) of the first insulation layer (2) and the bottom surface (26) are disposed opposite to each other, and the third part (14) of the first conductive layer (1) is located on a side that is of the third part (17) of the first insulation layer (2) and that is away from the bottom surface (26); and
a part of the first conductive member (51) is fastened to the third part (14) of the first conductive layer (1), and a part of the first conductive member (51) is fastened to the bottom surface of the second cover (20); and the first conductive layer (1) is electrically connected to the bottom surface of the second cover (20) through the first conductive member (51).

25. An electronic device (1000), comprising a support member and the vapor chamber (100) according to claims 1 to 24, wherein the vapor chamber (100) is installed on the support member.

26. The electronic device (1000) according to claim 25, wherein the electronic device (1000) further comprises a screen (400) and a housing (300), the screen (400) is installed in the housing (300), the screen (400) and the housing (300) enclose an accommodation space (1001), and the vapor chamber (100) is installed in the accommodation space (1001), wherein
the support member is the screen (400) or the housing (300).

27. The electronic device (1000) according to claim 26, wherein the housing (300) comprises a middle frame (310) and a rear cover (320), the middle frame (310) is connected between the screen (400) and the rear cover (320), the screen (400), the middle frame (310), and the rear cover (320) enclose the accommodation space (1001), and the support member is the middle frame (310) or the rear cover (320).

28. The electronic device (1000) according to claim 27, wherein a first conductive member (51) of the vapor chamber (100) is fastened to the middle frame (310) and electrically connected to the middle frame (310).

29. The electronic device (1000) according to claim 27, wherein the electronic device (1000) further comprises a first electrical connection member (901); and a part of the first electrical connection member (901) is fastened to the vapor chamber (100) and electrically connected to a first conductive layer (1) of the vapor chamber (100), and a part of the first electrical connection member (901) is fastened to the middle frame (310) and electrically connected to the middle frame (310).

30. The electronic device (1000) according to claim 29, wherein the vapor chamber (100) has an extension region (104), a gap exists between a bottom surface (1042) of the extension region (104) and the middle frame (310), and at least a part of the first electrical connection member (901) is located in the gap.

31. The electronic device (1000) according to claim 30, wherein the first electrical connection member (901) is a conductive slurry, a conductive adhesive, conductive foam, or a metal sheet.

32. An electronic device, comprising a housing (300), a screen (400), a vapor chamber, and an electrical connection structure, wherein the screen (400) is connected to the housing (300) to enclose an accommodation space, and both the vapor chamber and the electrical connection structure are installed in the accommodation space; and one end of the electrical connection structure is connected to the vapor chamber, and the other end of the electrical connection structure is connected to the housing (300) or the screen (400);
the vapor chamber comprises a first cover (10), a second cover (20), a capillary structure (30), and a cooling medium (40), the second cover (20) comprises an effective region (201) and an edge sealing region (202), and the edge sealing region (202) is connected to a peripheral edge of the effective region (201); a part of the first cover (10) is fastened to the edge sealing region (202) of the second cover (20), and a part of the first cover (10) is spaced from the effective region (201) of the second cover (20), to enclose an accommodating cavity (101); and the capillary structure (30) and the cooling medium (40) are located in the accommodating cavity (101);
the first cover (10) comprises a first conductive layer (1), a first insulation layer (2), and a second conductive layer (3), the first insulation layer (2) is connected between the first conductive layer (1) and the second conductive layer (3), and the second conductive layer (3) is located on a side that is of the first insulation layer (2) and that is close to the second cover (20); and
the second cover (20) is made of a conductive material; and a part of the electrical connection structure is electrically connected to the first conductive layer (1) and the second cover (20), and a part of the electrical connection structure is electrically connected to a ground end of the electronic device; or
the second cover (20) comprises a third conductive layer (21) and a second insulation layer (22) that are stacked, and the second insulation layer (22) is located on a side that is of the third conductive layer (21) and that is close to the second conductive layer (3); and a part of the electrical connection structure is electrically connected to the first conductive layer (1) and the third conductive layer (21), and a part of the electrical connection structure is electrically connected to a ground end of the electronic device.
